# EUROPEAN PATENT APPLICATION

(11) **EP 4 446 601 A1**
(43) Date of publication of application: **16.10.2024**
(21) Application number: 23746220.5
(22) Date of filing: 19.01.2023
(51) Int. Cl.: F16C 11/04

(54) **ROTATING SHAFT MECHANISM AND ELECTRONIC DEVICE**

(30) Priority: 30.01.2022 CN 202210114094; 10.01.2023 CN 202310036485
(71) Applicant: Huawei Technologies Co., Ltd., Shenzhen, Guangdong 518129 (CN)
(72) Inventor: WU, Weifeng, Shenzhen, Guangdong 518129 (CN); ZHONG, Ding, Shenzhen, Guangdong 518129 (CN); ZHAN, Qiang, Shenzhen, Guangdong 518129 (CN); HUA, Leilei, Shenzhen, Guangdong 518129 (CN); TIAN, Haiqiang, Shenzhen, Guangdong 518129 (CN); LIAO, Changliang, Shenzhen, Guangdong 518129 (CN); XIE, Zhi, Shenzhen, Guangdong 518129 (CN)
(74) Representative: Maiwald GmbH
(86) International application number: PCT/CN2023/073030
(87) International publication number: WO 2023/143339

(57) **Abstract**

Disclosed are a hinge mechanism and an electronic device. A hinge mechanism (1) includes a base (106) and a main hinge module (101). The main hinge module (101) includes two rotating components (101a, 101b), and each rotating component (101a, 101b) includes a support arm (1012, 1020), a swing arm (1013, 1021), and a housing mounting bracket (1015, 1019). The two support arms (1012, 1020) are respectively disposed on two sides of the base (106), and are rotatably connected to the base (106). The two swing arms (1013, 1021) are respectively disposed on two sides of the base (106), and are rotatably connected to the base (106). Rotation axes of a support arm (1012, 1020) and a swing arm (1013, 1021) located on a same side of the base (106) are parallel and do not coincide. The two housing mounting brackets (1015, 1019) are respectively disposed on two sides of the base (106), and each housing mounting bracket (1015, 1019) is provided with two sliding grooves (10151, 10152, 10191, 10192). For a support arm (1012, 1020), a swing arm (1013, 1021), and a housing mounting bracket (1015, 1019) that are located on a same side of the base (106), the support arm (1012, 1020) and the swing arm (1013, 1021) may separately slide in a sliding groove (10151, 10152, 10191, 10192), and projections of sliding directions of the support arm (1012, 1020) and the swing arm (1013, 1021) are not parallel in a reference plane perpendicular to the rotation axes of the support arm (1012, 1020) and the swing arm (1013, 1021). The hinge mechanism is used, so that reliability of a structure of the electronic device can be ensured. In addition, a display accommodation space that meets a bending requirement of a flexible display can be formed, to reduce a risk of damaging the flexible display.

## Description

### CROSS-REFERENCE TO RELATED APPLICATIONS

This application claims priority to Chinese Patent Application No. 202210114094.X, filed with the China National Intellectual Property Administration on January 30, 2022 and entitled "HINGE MECHANISM AND ELECTRONIC DEVICE", and this application claims priority to Chinese Patent Application No. 202310036485.9, filed with the China National Intellectual Property Administration on January 10, 2023 and entitled "HINGE MECHANISM AND ELECTRONIC DEVICE", both of which are incorporated herein by reference in their entireties.

### TECHNICAL FIELD

This application relates to the field of electronic device technologies, and in particular, to a hinge mechanism and an electronic device.

### BACKGROUND

With gradual maturation of flexible display technologies, a display mode of an electronic device is driven to greatly change. A mobile phone with a foldable flexible display, a tablet computer with a foldable flexible display, a wearable electronic device with a foldable flexible display, and the like are an important evolution direction of intelligent electronic devices in the future.

A flexible display is a key component in a foldable electronic device, and has features of continuity and foldability. A hinge mechanism is an important component for implementing a folding function of the foldable electronic device. To prevent the hinge mechanism from pulling or squeezing the flexible display in a rotation process, avoidance processing usually needs to be performed on the hinge mechanism and a component that interferes with rotation of the hinge mechanism in the electronic device. This leads to existence of components with thin walls in the hinge mechanism and the electronic device. Consequently, reliability of an overall structure of the electronic device is affected.

Therefore, providing a hinge mechanism that can meet a folding requirement of the flexible display while ensuring the reliability of the overall structure of the electronic device has become a major problem to be urgently resolved by a person skilled in the art.

### SUMMARY

This application provides a hinge mechanism and an electronic device, to improve reliability of an overall structure of the electronic device, reduce a risk of damaging a flexible display, and prolong a service life of the flexible display.

According to a first aspect, this application provides a hinge mechanism. The hinge mechanism may be used in a foldable electronic device, and the hinge mechanism is disposed corresponding to a flexible display of the electronic device. When the hinge mechanism is specifically disposed, the hinge mechanism may include a base and a main hinge module. The main hinge module may include a first rotating component and a second rotating component, and the first rotating component and the second rotating component are respectively disposed on two opposite sides of the base. The first rotating component includes a first support arm, a first swing arm, and a first housing mounting bracket. The second rotating component includes a second support arm, a second swing arm, and a second housing mounting bracket. The first support arm and the second support arm are separately rotatably connected to the base, and the first swing arm and the second swing arm are separately rotatably connected to the base. A rotation axis of the first support arm is parallel to and does not coincide with a rotation axis of the first swing arm, and a rotation axis of the second support arm is parallel to and does not coincide with a rotation axis of the second swing arm. In addition, a first sliding groove extending in a first direction and a second sliding groove extending in a second direction are disposed on the first housing mounting bracket. In this way, the first support arm is capable of sliding in the first sliding groove along the first direction, and the first swing arm is capable of sliding in the second sliding groove. In addition, a projection in the first direction in a first cross section is not parallel to a projection in the second direction in the first cross section. The first cross section is a reference plane perpendicular to the rotation axis of the first support arm and the rotation axis of the first swing arm. Similarly, a third sliding groove extending in a third direction and a fourth sliding groove extending in a fourth direction are disposed on the second housing mounting bracket. In this way, the second support arm is capable of sliding in the third sliding groove, and the third swing arm is capable of sliding in the fourth sliding groove. In addition, a projection in the third direction in a second cross section is not parallel to a projection in the fourth direction in the second cross section. The second cross section is a reference plane perpendicular to the rotation axis of the second support arm and the rotation axis of the second swing arm.

The hinge mechanism provided in this application is used, the rotation axis of the first support arm does not coincide with the rotation axis of the first swing arm, and the rotation axis of the second support arm does not coincide with the rotation axis of the second swing arm, so that an axis center phase difference between a support arm and a swing arm that are disposed on a same side can be implemented in a rotation process of the hinge mechanism, thereby implementing telescopic motion of the two rotating components. In this way, the hinge mechanism can stably support the flexible display of the electronic device when the hinge mechanism is in an unfolded state, and a water-drop-like display accommodation space can be formed to meet a bending requirement of the flexible display when the hinge mechanism is in a folded state. In addition, in this application, disposing directions of the first sliding groove and the second sliding groove of the first housing mounting bracket and disposing directions of the third sliding groove and the fourth sliding groove of the second housing mounting bracket are properly designed, so that angles at which the first swing arm and the second swing arm rotate relative to the base can be reduced. In this way, wall thickness designs of local structures of the first swing arm and the second swing arm can meet strength requirements, thereby improving reliability of structures of the first swing arm and the second swing arm. When being used in the electronic device, the hinge mechanism can effectively avoid a case in which a component in the electronic device is thinned, to avoid rotation of the first swing arm and the second swing arm. This can improve reliability of an overall structure of the electronic device, and can reduce a risk of squeezing the flexible display of the electronic device caused by rotation of the first swing arm and the second swing arm, reduce a risk of damaging the flexible display, and prolong a service life of the flexible display.

It can be learned from the foregoing description of a rotation principle of the hinge mechanism provided in this application that, in this application, the disposing directions of the first sliding groove and the second sliding groove of the first housing mounting bracket are properly designed, so that angles at which the first support arm and the first swing arm rotate relative to the base may be adjusted. For example, neither of the angles at which the first support arm and the first swing arm rotate relative to the base may be greater than 90°. Similarly, the disposing directions of the third sliding groove and the fourth sliding groove of the second housing mounting bracket are properly designed, so that angles at which the second support arm and the second swing arm rotate relative to the base may be adjusted. For example, neither of the angles at which the second support arm and the second swing arm rotate relative to the base may be greater than 90°. In this way, the angles at which the first swing arm and the second swing arm rotate relative to the base can be small, so that another structure of the hinge mechanism can avoid rotation of the first swing arm and the second swing arm. This can help increase wall thicknesses of the local structures of the first swing arm and the second swing arm. Therefore, the reliability of the structures of the first swing arm and the second swing arm is improved.

In this application, there are a plurality of manners of rotatably connecting the first swing arm and the second swing arm to the base. For example, a first arc-shaped slot and a second arc-shaped slot may be disposed on the base, and a first arc-shaped rotation block is disposed at an end that is of the first swing arm and that is used to rotatably connect to the base. The first arc-shaped rotation block may be accommodated in the first arc-shaped slot and is capable of rotating along an arc-shaped surface of the first arc-shaped slot. In addition, a second arc-shaped block is disposed at an end that is of the second swing arm and that is used to rotatably connect to the base. The second arc-shaped rotation block may be accommodated in the second arc-shaped slot and is capable of rotating along an arc-shaped surface of the second arc-shaped slot. In this way, the first swing arm and the second swing arm can be rotatably connected to the base by accommodating the arc-shaped rotation blocks in the arc-shaped slots and rotating the arc-shaped rotation blocks along the arc-shaped surfaces of the arc-shaped slots. Therefore, the first swing arm and the second swing arm are rotatably connected to the base by using virtual shafts. This can effectively reduce space occupied by the first swing arm and the second swing arm on the base, thereby helping implement a compact design of the hinge mechanism.

In addition, the main hinge module may further include a cover plate, and the cover plate covers the base, to form an accommodation space between the base and the cover plate. In addition, a first arc-shaped protrusion may further be disposed on a surface that is of the cover plate and that faces the first arc-shaped slot, and the first arc-shaped rotation block of the first swing arm may be inserted between the first arc-shaped protrusion and the first arc-shaped slot, to limit the first arc-shaped rotation block on the base, so as to prevent the first arc-shaped rotation block from falling off from the base, and improve reliability of a connection between the first swing arm and the base. Similarly, a second arc-shaped protrusion may further be disposed on a surface that is of the cover plate and that faces the second arc-shaped slot, and the second arc-shaped rotation block of the second swing arm may be inserted between the second arc-shaped protrusion and the second arc-shaped slot, to limit the second arc-shaped rotation block on the base, so as to prevent the second arc-shaped rotation block from falling off from the base, and improve reliability of a connection between the second swing arm and the base.

In a possible implementation of this application, the first arc-shaped slot and the second arc-shaped slot may alternatively be of an integrated channel structure directly disposed on the base. This can effectively simplify a structure of the base while ensuring reliability of a connection between the first arc-shaped rotation block and the first arc-shaped slot and reliability of a connection between the second arc-shaped rotation block and the second arc-shaped slot.

In a possible implementation of this application, a first sliding rail may be disposed on a groove wall of the first sliding groove of the first housing mounting bracket, and a first sliding block may be disposed on the first support arm. The first sliding block may be clamped in the first sliding rail and is capable of sliding along the first sliding rail. This can prevent the first support arm from falling off from the first housing mounting bracket. The first sliding rail can provide guidance for sliding of the first support arm, and this improves reliability of sliding the first support arm along the first housing mounting bracket.

In addition, a second sliding rail may be disposed on a groove wall of the second sliding groove of the first housing mounting bracket, and a second sliding block is disposed on the first swing arm. The second sliding block may be clamped in the second sliding rail and is capable of sliding along the second sliding rail. This can prevent the first swing arm from falling off from the first housing mounting bracket. The second sliding rail can provide guidance for sliding of the first swing arm, and this improves reliability of sliding the first swing arm along the first housing mounting bracket.

Similarly, a third sliding rail is disposed on a groove wall of the third sliding groove of the second housing mounting bracket, and a third sliding block is disposed on the second support arm. The third sliding block may be clamped in the third sliding rail and is capable of sliding along the third sliding rail. This can prevent the second support arm from falling off from the second housing mounting bracket. The third sliding rail can provide guidance for sliding of the second support arm, and this improves reliability of sliding the second support arm along the second housing mounting bracket.

In addition, a fourth sliding rail may be disposed on a groove wall of the fourth sliding groove of the second housing mounting bracket, and a fourth sliding block is disposed on the second swing arm. The fourth sliding block may be clamped in the fourth sliding rail and is capable of sliding along the fourth sliding rail. This can prevent the second swing arm from falling off from the second housing mounting bracket. The fourth sliding rail can provide guidance for sliding of the second swing arm, and this improves reliability of sliding the second swing arm along the second housing mounting bracket.

In this application, when the second sliding block is specifically disposed, the second sliding block may be a straight-line sliding block. In this case, the second sliding rail may be adaptively disposed as a straight-line sliding rail. This can effectively simplify processing processes of the second sliding block and the second sliding rail. Similarly, when the fourth sliding block is specifically disposed, the fourth sliding block may be a straight-line sliding block. In this case, the fourth sliding rail may be adaptively disposed as a straight-line sliding rail. This can effectively simplify processing processes of the fourth sliding block and the fourth sliding rail. It may be understood that the second sliding block herein may alternatively be in another shape that adapts to the straight-line sliding rail, for example, may be a sliding block in an overall straight-line form with a hollow and spacing design in a middle part, or may be some specially shaped sliding blocks, as long as the sliding block can fit the sliding rail in the straight-line form for sliding.

In a possible implementation of this application, the first housing mounting bracket includes a first surface, and the first surface is a surface of a side that is of the first housing mounting bracket and that faces the flexible display. The second sliding block may be the straight-line sliding block. In this case, the second sliding rail may be adaptively disposed as the straight-line sliding rail. The straight-line sliding rail has an opening located on the first surface. In this case, when the hinge mechanism is in the unfolded state, the straight-line sliding rail may extend from the opening to the base. This can help improve smoothness of sliding the second sliding block along the second sliding rail, and effectively reduce interference of the another structure of the hinge mechanism to motion of the first swing arm. Therefore, a wall thickness of the first swing arm is increased. In another possible implementation of this application, the straight-line sliding rail may alternatively extend from the opening to a direction away from the base. Alternatively, when the first housing mounting bracket further includes a second surface disposed opposite to the first surface, the straight-line sliding rail may alternatively extend from the opening to a direction perpendicular to the second surface. In this way, the second sliding rail is disposed flexibly. Herein, the unfolded state of the hinge mechanism is a state corresponding to the hinge mechanism when the electronic device is in the unfolded state.

In addition, the second housing mounting bracket includes a third surface, and the third surface is a surface of a side that is of the second housing mounting bracket and that faces the flexible display. The fourth sliding block may be the straight-line sliding block. In this case, the fourth sliding rail may be adaptively disposed as the straight-line sliding rail. The straight-line sliding rail has an opening located on the third surface. In this case, when the hinge mechanism is in the unfolded state, the straight-line sliding rail may extend from the opening to the base. This can help improve smoothness of sliding the fourth sliding block along the fourth sliding rail, and effectively reduce interference of the another structure of the hinge mechanism to motion of the second swing arm. Therefore, a wall thickness of the second swing arm is increased. In another possible implementation of this application, the straight-line sliding rail may alternatively extend from the opening to the direction away from the base. Alternatively, when the second housing mounting bracket further includes a fourth surface disposed opposite to the third surface, the straight-line sliding rail may alternatively extend from the opening to a direction perpendicular to the fourth surface. In this way, the fourth sliding rail is disposed flexibly.

In some possible implementations, the second sliding block may alternatively be disposed as an arc-shaped sliding block, and the second sliding rail is adaptively disposed as an arc-shaped sliding rail. This can reduce a risk of detaching the second sliding block from the second sliding rail, thereby helping improve reliability of cooperation between the second sliding block and the second sliding rail. In addition, the fourth sliding block may also be disposed as an arc-shaped sliding block, and the fourth sliding rail is adaptively disposed as an arc-shaped sliding rail. This can reduce a risk of detaching the fourth sliding block from the fourth sliding rail, thereby helping improve reliability of cooperation between the fourth sliding block and the fourth sliding rail. It may be understood that the second sliding block herein may alternatively be in another shape that adapts to the arc-shaped sliding rail, for example, may be a sliding block in an overall arc-shaped form with a hollow and spacing design in a middle part, or may be some specially shaped sliding blocks, as long as the sliding block can fit the sliding rail in the arc-shaped form for sliding.

In addition, when the hinge mechanism is in the unfolded state, an axis center of the arc-shaped sliding rail may be located on a side that is of the arc-shaped sliding rail and that is away from the base. This can help improve smoothness of sliding the second sliding block along the second sliding rail and smoothness of sliding the fourth sliding block along the fourth sliding rail, and effectively reduce interference of the another structure of the hinge mechanism to motion of the first swing arm and the second swing arm. Therefore, wall thicknesses of the first swing arm and the second swing arm can be increased. In another possible implementation of this application, when the hinge mechanism is in the unfolded state, an axis center of the arc-shaped sliding rail may alternatively be located on a side that is of the arc-shaped sliding rail and that faces the base, so that the second sliding rail and the fourth sliding rail are disposed flexibly.

In this application, the main hinge module may further include a first drive connecting rod and a second drive connecting rod. The first drive connecting rod is disposed between the first support arm and the first swing arm. The first drive connecting rod includes a first connection part and a second connection part, the first connection part is rotatably connected to the first support arm through a first connecting rod, and the second connection part is rotatably connected to the first swing arm through a second connecting rod. Axes of the first connecting rod and the second connecting rod do not coincide. In addition, the second drive connecting rod includes a third connection part and a fourth connection part, the third connection part is rotatably connected to the second support arm through a third connecting rod, and the fourth connection part is rotatably connected to the second swing arm through a fourth connecting rod. Axes of the third connecting rod and the fourth connecting rod do not coincide.

This can effectively improve degrees of bonding between the first support arm and the first swing arm and the corresponding sliding grooves and degrees of bonding between the second support arm and the second swing arm and the corresponding sliding grooves. Therefore, motion consistency between the first support arm and the first swing arm and motion consistency between the second support arm and the second swing arm are improved, and motion of the first support arm and the first swing arm, and motion of the second support arm and the second swing arm are smoother. In addition, when the electronic device in which the hinge mechanism is used falls in the folded state, the first support arm and the first swing arm may jointly support a corresponding housing in the electronic device, and the second support arm and the second swing arm may jointly support a corresponding housing in the electronic device. Therefore, motion of the two housings relative to the hinge mechanism can be avoided. This improves the reliability of the overall structure of the electronic device.

In addition to the foregoing manner in which the first drive connecting rod and the second drive connecting rod are disposed, in another possible implementation, the first drive connecting rod is located between the first support arm and the first swing arm, the first drive connecting rod includes a first connection part and a second connection part, the first connection part is slidably connected to the first swing arm through a first connecting rod, and the second connection part is fastened to the first support arm. In addition, the second drive connecting rod is located between the second support arm and the second swing arm, the second drive connecting rod includes a third connection part and a fourth connection part, the third connection part is slidably connected to the second swing arm through a third connecting rod, and the fourth connection part is fastened to the second support arm.

To implement a slidable connection between the first connecting rod and the first swing arm, a first guiding slot may be disposed at an end that is of the first swing arm and that faces the first support arm, so that the first connecting rod can be inserted into the first guiding slot and is capable of sliding along a slot surface of the first guiding slot. In addition, the first drive connecting rod and the first support arm may be integrally formed, to simplify a structure of the main hinge module. Similarly, to implement a slidable connection between the second connecting rod and the second swing arm, a second guiding slot may be disposed at an end that is of the second swing arm and that faces the second support arm, so that the second connecting rod can be inserted into the second guiding slot and is capable of sliding along a slot surface of the second guiding slot. In addition, the second drive connecting rod and the second support arm may be integrally formed, to simplify the structure of the main hinge module.

The first drive connecting rod and the second drive connecting rod are disposed in the manner provided in this implementation. The first guiding slot and the second guiding slot may be properly designed, to improve the degrees of bonding between the first support arm and the first swing arm and the corresponding sliding grooves and the degrees of bonding between the second support arm and the second swing arm and the corresponding sliding grooves. Therefore, the motion consistency between the first support arm and the first swing arm and the motion consistency between the second support arm and the second swing arm are improved, and the motion of the first support arm and the first swing arm and the motion of the second support arm and the second swing arm are smoother. In addition, when the electronic device in which the hinge mechanism is used falls in the folded state, the first support arm, the first swing arm, and the first drive connecting rod may jointly support a corresponding housing in the electronic device, and the second support arm, the second swing arm, and the second drive connecting rod may jointly support a corresponding housing in the electronic device. Therefore, large instantaneous displacements of the two housings relative to the hinge mechanism can be avoided. This improves the reliability of the overall structure of the electronic device.

In addition, to avoid over-constraints on motion of the first support arm and the first swing arm and motion of the second support arm and the second swing arm, in a possible implementation of this application, when the second sliding rail is disposed on the second sliding groove of the first housing mounting bracket, and the second sliding block capable of sliding along the second sliding rail is disposed on the first swing arm, the second sliding block is in clearance fit with the second sliding rail, to increase a degree of freedom of motion of the first swing arm. Similarly, when the fourth sliding rail is disposed on the fourth sliding groove of the second housing mounting bracket, and the fourth sliding block capable of sliding along the fourth sliding rail is disposed on the second swing arm, the fourth sliding block may be in clearance fit with the fourth sliding rail, to increase a degree of freedom of motion of the second swing arm.

When the second sliding block is in clearance fit with the second sliding rail, a shape of the second sliding block may match a shape of the second sliding rail. For example, when the second sliding rail is a rectangular sliding rail, the second sliding block may be disposed as a rectangular sliding block. Alternatively, the second sliding block may be disposed as a pin shaft, to simplify a structure of the second sliding block. Similarly, when the fourth sliding block is in clearance fit with the fourth sliding rail, a shape of the fourth sliding block may match a shape of the fourth sliding rail. For example, when the fourth sliding rail is a rectangular sliding rail, the fourth sliding block may be disposed as a rectangular sliding block. Alternatively, the fourth sliding block may be disposed as a pin shaft, to simplify a structure of the fourth sliding block.

In a possible implementation of this application, the hinge mechanism may further include a first support plate and a second support plate. The first support plate and the second support plate are respectively disposed on two sides of the base. The first support plate is rotatably connected to the first housing mounting bracket, and the first support plate is slidably connected to the first support arm and/or the first swing arm. The second support plate is rotatably connected to the second housing mounting bracket, and the second support plate is slidably connected to the second support arm and/or the second swing arm. In addition, when the first housing mounting bracket and the second housing mounting bracket rotate toward each other, an end that is of the first support plate and that is close to the base moves in a direction away from the base, and an end that is of the second support plate and that is close to the base moves in a direction away from the base, so that a triangular display accommodation space can be formed between the two support plates and the base. In this way, when the hinge mechanism is used in the electronic device, and the electronic device is in the folded state, a bent part of the flexible display may be accommodated in the display accommodation space and present as a type of water drop form. This can avoid pulling or squeezing the flexible display, thereby reducing the risk of damaging the flexible display.

To implement rotation of a first support plate around the first housing mounting bracket, a first rotating slot may be disposed on the first housing mounting bracket, and a first rotating part is disposed on the first support plate. In this way, the first rotating part can be mounted in the first rotating slot, and the first rotating part is capable of rotating along a slot surface of the first rotating slot. Similarly, to implement rotation of a second support plate around the second housing mounting bracket, a second rotating slot may be disposed on the second housing mounting bracket, and a second rotating part may be disposed on the second support plate. In this way, the second rotating part can be mounted in the second rotating slot, and the second rotating part is capable of rotating along a slot surface of the second rotating slot.

It can be learned from the foregoing description of the hinge mechanism that, when the two housing mounting brackets rotate toward each other, the two support plates rotate around the corresponding housing mounting brackets, so that the display accommodation space can be formed. To form, between the two support plates, the display accommodation space that meets a bending requirement of the flexible display, motion tracks of the support plates may be properly designed. In a possible implementation of this application, a first guiding part may be disposed on the first support plate, and a first track slot is disposed on the first guiding part. In addition, a first guiding structure may be disposed on the first support arm, and the first guiding structure may be inserted into the first track slot and is capable of sliding along the first track slot, and/or the first guiding structure is disposed on the first support arm, and the first guiding structure is inserted into the first track slot and is capable of sliding along the first track slot. Therefore, in a process in which the first swing arm and/or the first support arm rotate/rotates around the base, the first support plate may be driven to rotate around the first housing mounting bracket, and the motion track of the first support plate can be adjusted by sliding the first guiding structure in the first track slot.

Similarly, a second guiding part may be disposed on the second support plate, and a second track slot is disposed on the second guiding part. In addition, a second guiding structure may be disposed on the second support arm, and the second guiding structure may be inserted into the second track slot and is capable of sliding along the second track slot, and/or the second guiding structure is disposed on the second support arm, and the second guiding structure is inserted into the second track slot and is capable of sliding along the second track slot. Therefore, in a process in which the second swing arm and/or the second support arm rotate/rotates around the base, the second support plate may be driven to rotate around the second housing mounting bracket, and the motion track of the second support plate is adjusted by sliding the second guiding structure in the second track slot. Further, the display accommodation space that meets a display accommodation requirement can be formed between the two support plates.

When the first guiding structure is specifically disposed, an example in which the first guiding structure is disposed on the first swing arm is used. A first protrusion may be disposed at an end of the first guiding structure. The first swing arm may have a first plugging hole, and a first groove is disposed on a hole wall of the first plugging hole. The first guiding structure may be inserted into the first plugging hole, and the first protrusion is clamped with the first groove. When the first guiding structure needs to be detached from the first swing arm, large pull-out force may be applied to the first guiding structure. This can implement a detachable connection between the first guiding structure and the first swing arm, so that connection components between the first guiding structure and the first swing arm can be effectively reduced while reliability of a connection between the first guiding structure and the first swing arm is ensured. Therefore, a structure of the hinge mechanism is simplified, and maintenance convenience of the hinge mechanism is improved. In this application, the first guiding structure may alternatively be disposed on the first support arm, and a first protrusion is disposed at an end of the first guiding structure. The first support arm has a first plugging hole, and a first groove is disposed on a hole wall of the first plugging hole. The first guiding structure may be inserted into the first plugging hole, and the first protrusion is clamped with the first groove. This implements a detachable connection between the first guiding structure and the first swing arm, so that connection components between the first guiding structure and the first swing arm can be effectively reduced while reliability of a connection between the first guiding structure and the first swing arm is ensured. Therefore, a structure of the hinge mechanism is simplified, and maintenance convenience of the hinge mechanism is improved.

Similarly, the second guiding structure may be disposed on the second swing arm, and a second protrusion is disposed at an end of the second guiding structure. The second swing arm has a second plugging hole, and a second groove is disposed on a hole wall of the second plugging hole. The second guiding structure may be inserted into the second plugging hole, and the second protrusion is clamped with the second groove. When the second guiding structure needs to be detached from the second swing arm, large pull-out force may be applied to the second guiding structure. This can implement a detachable connection between the second guiding structure and the second swing arm, so that connection components between the second guiding structure and the second swing arm can be effectively reduced while reliability of a connection between the second guiding structure and the second swing arm is ensured. Therefore, the structure of the hinge mechanism is simplified, and the maintenance convenience of the hinge mechanism is improved. Alternatively, the second guiding structure is disposed on the second support arm, and a second protrusion is disposed at an end of the second guiding structure. The second support arm has a second plugging hole, and a second groove is disposed on a hole wall of the second plugging hole. The second guiding structure is inserted into the second plugging hole, and the second protrusion is clamped with the second groove. This implements a detachable connection between the second guiding structure and the second support arm, so that connection components between the second guiding structure and the second support arm can be effectively reduced while reliability of a connection between the second guiding structure and the second support arm is ensured. Therefore, the structure of the hinge mechanism is simplified, and the maintenance convenience of the hinge mechanism is improved.

In another possible implementation of this application, when the first guiding structure is specifically disposed, the first guiding structure may be rotatably connected to the first swing arm, and/or the first guiding structure may be rotatably connected to the first support arm. Similarly, the second guiding structure is rotatably connected to the second swing arm, and/or the second guiding structure is rotatably connected to the second support arm. The first guiding structure is rotatably connected to the first swing arm and/or the first support arm, and the first guiding structure slides along the first track slot of the first support plate, so that stability that the first swing arm and/or the first support arm drive/drives the first support plate to move can be effectively improved. Similarly, the second guiding structure is rotatably connected to the second swing arm and/or the second support arm, and the second guiding structure slides along the second track slot of the second support plate, so that stability that the second swing arm and/or the second support arm drive/drives the second support plate to move can be effectively improved. In addition, when the electronic device is in the unfolded state, flatness of the first support plate and the second support plate for supporting the flexible display can further be effectively improved. In addition, when the electronic device is in the folded state, a risk of squeezing the flexible display by the first support plate and the second support plate in a process in which the entire device falls can be reduced, to improve reliability of the structure of the entire device.

When the first guiding structure is rotatably connected to the first swing arm and/or the first support arm, to facilitate sliding of the first guiding structure in the first track slot, the first track slot may have a first opening. When the hinge mechanism is in the unfolded state, the first opening is disposed toward the base, so that the first guiding structure can be inserted into the first track slot through the first opening.

Similarly, when the second guiding structure is rotatably connected to the second swing arm and/or the second support arm, to facilitate sliding of the second guiding structure in the second track slot, the second track slot may have a second opening. When the hinge mechanism is in the unfolded state, the second opening is disposed toward the base, so that the second guiding structure can be inserted into the second track slot through the second opening.

In a possible implementation of this application, the main hinge module may further include a synchronization component, the synchronization component may include a first drive gear disposed at an end of the first support arm and a second drive gear disposed at an end of the second support arm, and the two drive gears are meshed with each other. In this way, when one support arm rotates around the base, the other support arm can be driven to synchronously rotate at a same angle in a toward or opposite direction.

In addition, because the two support arms are respectively slidably connected to the housing mounting brackets located on the same side of the base, synchronous rotation of the two housing mounting brackets can be implemented through synchronous rotation of the two support arms. In addition, when the hinge mechanism is used in the electronic device, each of the two housing mounting brackets may be fastened to one housing of the electronic device, so that synchronous rotation of the two housings of the electronic device can be implemented, and instantaneous force can be prevented from being applied to the flexible display fastened to the two housings. This helps improve reliability of the flexible display.

In addition, the synchronization component may further include an even number of driven gears, and the even number of driven gears may be disposed between the two drive gears, so that the two drive gears implement synchronous rotation through the even number of driven gears. This helps improve stability of motion of the synchronization component, and improves reliability of synchronous rotation of the two support arms.

In addition to the foregoing structure, a damping component may further be disposed in the main hinge module. The damping component may include a first elastic member and a first conjoined cam, and the first conjoined cam may be located between the first elastic member and the first support arm. In addition, a first cam surface may be disposed at an end that is of the first support arm and that faces the first conjoined cam, a second cam surface may be disposed at an end that is of the second support arm and that faces the first conjoined cam, a third cam surface may be disposed at an end that is of the first conjoined cam and that faces the first support arm, and a fourth cam surface may be disposed at an end facing the second support arm. Under action of elastic force of the first elastic member, the corresponding first cam surface cooperates with the third cam surface, and the second cam surface cooperates with the fourth cam surface. In this way, in a process in which the two support arms rotate around the base, damping force can be generated between cam surfaces cooperating with each other, and the damping force blocks rotation of the support arms on corresponding sides. The damping force may be transmitted to the housing mounting brackets on the corresponding sides through the two support arms, so that the housing mounting brackets act on the housings of the electronic device. This can avoid false unfolding and folding of the electronic device, and can implement hovering of the two housings at a set position. In addition, a user may have an obvious feeling in a process of unfolding or folding the electronic device. This helps improve user experience.

According to a second aspect, this application further provides an electronic device. The electronic device includes a first housing, a second housing, a flexible display, and the hinge mechanism according to the first aspect. The first housing and the second housing are respectively disposed on two opposite sides of the hinge mechanism, a first housing mounting bracket is fastened to the first housing, and a second housing mounting bracket is fastened to the second housing. In addition, the flexible display may contiguously cover the first housing, the second housing, and the hinge mechanism, and the flexible display is fastened to the first housing and the second housing.

According to the electronic device provided in this application, when the electronic device is in an unfolded state, the hinge mechanism can flatly support the flexible display. This can ensure that a form of the electronic device in the unfolded state is complete, and help improve light and shadow of the flexible display. In a process in which the electronic device rotates around the hinge mechanism from the unfolded state to a folded state, the two housings of the electronic device may respectively drive the housing mounting brackets on corresponding sides to rotate around the base. Therefore, the housing mounting bracket can drive a support arm and a swing arm that are disposed on a same side to rotate around the base. In addition, disposing directions of a first sliding groove and a second sliding groove of the first housing mounting bracket and disposing directions of a third sliding groove and a fourth sliding groove of the second housing mounting bracket are properly designed, so that angles at which a support arm and a swing arm on a corresponding side rotate relative to the base can be adjusted. This can avoid thinning a component of the electronic device, avoid rotation of two swing arms, and improve reliability of an overall structure of the electronic device. In addition, when the electronic device is in the folded state, distances between the two swing arms and the flexible display are long, to prevent the two swing arms from squeezing or pulling the flexible display. This reduces a risk of damaging the flexible display, and prolongs a service life of the flexible display.

In addition, in this application, when the hinge mechanism further includes a first support plate and a second support plate, the first support plate and the second support plate are respectively disposed on two sides of the base, the first support plate is rotatably connected to the first housing mounting bracket, and the second support plate is rotatably connected to the second housing mounting bracket. In this case, the flexible display may be bonded to the first support plate and the second support plate.

Specifically, the flexible display may be bonded to a partial area of the first support plate, and the flexible display may be bonded to a partial area of the second support plate. Therefore, when the electronic device is in the unfolded state, the first housing, the second housing, the first support plate, and the second support plate jointly stably support the flexible display. In a process in which the electronic device changes from the unfolded state to the folded state, the two support plates can drive the flexible display to rotate. This can effectively avoid deformation of the flexible display, and reduce the risk of damaging the flexible display. In addition, when the electronic device is in the folded state, the flexible display can be attached to the two support plates. This can help improve light and shadow of the flexible display.

In addition, track slots of the first support plate and the second support plate can be properly designed, so that when the electronic device is in the folded state, enough display accommodation space is formed between the two support plates and a cover plate to accommodate a bent part of the flexible display. This can avoid a gap at the hinge mechanism of the electronic device, and ensure that a form of the electronic device in the folded state is complete. In this way, damage to the flexible display caused by a foreign matter inserted into the electronic device at the hinge mechanism can be avoided, and an overall thickness of the electronic device can be thinned.

In a possible implementation of this application, the electronic device may further include an end cover. The end cover may be located on a side that is of the base and that is away from the flexible display, and the end cover and the base may be integrally formed. In this way, the end cover can protect the hinge mechanism, and appearance aesthetics of the electronic device can be effectively improved.

### BRIEF DESCRIPTION OF DRAWINGS

FIG. 1 is a schematic diagram of a structure of an electronic device in a folded state according to an embodiment of this application;
FIG. 2 is a schematic diagram of a structure of an electronic device in an unfolded state according to an embodiment of this application;
FIG. 3 is a schematic diagram of a motion principle of a hinge mechanism in the conventional technology according to an embodiment of this application;
FIG. 4 is a schematic diagram of an exploded structure of an electronic device according to an embodiment of this application;
FIG. 5a is a schematic diagram of an exploded structure of a hinge mechanism according to an embodiment of this application;
FIG. 5b is an exploded view of a partial structure of a hinge mechanism according to an embodiment of this application;
FIG. 6 is a schematic diagram of a partial structure of a hinge mechanism according to an embodiment of this application;
FIG. 7 is a schematic diagram of a structure of a swing arm according to an embodiment of this application;
FIG. 8 is a schematic diagram of a partial structure of a hinge mechanism according to another embodiment of this application;
FIG. 9 is a schematic diagram of a structure of a housing mounting bracket according to an embodiment of this application;
FIG. 10a is a schematic diagram of a structure of a hinge mechanism in an unfolded state according to an embodiment of this application;
FIG. 10b is a schematic diagram of a first cross section according to an embodiment of this application;
FIG. 10c is a schematic diagram of a structure of a hinge mechanism in an intermediate state according to an embodiment of this application;
FIG. 10d is a schematic diagram of a structure of a hinge mechanism in a folded state according to an embodiment of this application;
FIG. 11 is a diagram of a principle of a mechanism in which a support arm and a swing arm slide relative to a housing mounting bracket according to an embodiment of this application;
FIG. 12 is a schematic diagram of a structure of a swing arm according to another embodiment of this application;
FIG. 13a is a schematic diagram of a structure of a hinge mechanism in an unfolded state according to an embodiment of this application;
FIG. 13b is a schematic diagram of a first cross section according to another embodiment of this application;
FIG. 13c is a schematic diagram of a first cross section according to another embodiment of this application;
FIG. 13d is a schematic diagram of a first cross section according to another embodiment of this application;
FIG. 14 is a schematic diagram of a structure of a hinge mechanism in an intermediate state according to an embodiment of this application;
FIG. 15 is a schematic diagram of a structure of a hinge mechanism in a folded state according to an embodiment of this application;
FIG. 16a is a schematic diagram of a structure in which a support arm is connected to a swing arm according to an embodiment of this application;
FIG. 16b is a schematic diagram of a structure of a first drive connecting rod according to an embodiment of this application;
FIG. 16c is a schematic diagram of a structure of a first support arm according to an embodiment of this application;
FIG. 17 is a sectional view at a position B-B in FIG. 16a;
FIG. 18 is a sectional view at a position C-C in FIG. 16a;
FIG. 19 is a schematic diagram of a structure of a swing arm according to another embodiment of this application;
FIG. 20a is a schematic diagram of a structure in which a first support arm is connected to a first swing arm according to another embodiment of this application;
FIG. 20b is a schematic diagram of a structure of a first swing arm according to another embodiment of this application;
FIG. 20c is a schematic diagram of a structure in which a first drive connecting rod is connected to a first support arm according to an embodiment of this application;
FIG. 21 is a schematic diagram of a structure of a support plate according to an embodiment of this application;
FIG. 22 is a schematic diagram of a structure supporting a flexible display by a support plate according to an embodiment of this application;
FIG. 23 is a sectional view of a hinge mechanism according to an embodiment of this application;
FIG. 24 is a sectional view of a hinge mechanism in a folded state according to an embodiment of this application;
FIG. 25 is a schematic diagram of a partial structure of a hinge mechanism according to another embodiment of this application;
FIG. 26 is a sectional view of the hinge mechanism shown in FIG. 25;
FIG. 27 is a sectional view of a hinge mechanism according to another embodiment of this application;
FIG. 28 is a schematic diagram of a structure of a first support plate according to another embodiment of this application;
FIG. 29 is a schematic diagram of a partial structure of a hinge mechanism according to another embodiment of this application;
FIG. 30 is a sectional view at a position D-D in FIG. 29; and
FIG. 31 is a schematic diagram of a partial structure of a hinge mechanism according to another embodiment of this application.

### Reference numerals:

1: hinge mechanism; 101: main hinge module; 101a: first rotating component; 101b: second rotating component;
1012: first support arm; 10121: first sliding block; 10122: first mounting hole;
1013: first swing arm; 10131: first arc-shaped rotation block; 10132: second sliding block; 10133: first guiding structure;
101331: first protrusion; 10134: first guiding slot; 10135: second mounting hole; 10136: first plugging hole;
101361: first groove;
1014: cover plate; 10141: first arc-shaped protrusion; 10142: second arc-shaped protrusion;
1015: first housing mounting bracket; 1015a: first surface; 1015b: second surface; 10151: first sliding groove;
101511: first sliding rail; 10152: second sliding groove; 101521: second sliding rail; 10153: first rotating slot;
1016a: first drive connecting rod; 10161: first connection part; 10162: second connection part; 10163: first connecting rod;
10164: second connecting rod; 1016b: second drive connecting rod;
1017: synchronization component; 10171a: first drive gear; 10171b: second drive gear; 10172: driven gear;
10173: intermediate shaft;
1018: damping component; 10181: first elastic member; 10182: first conjoined cam; 10183: stopper;
10184: circlip; 10185: second conjoined cam; 10186: third conjoined cam; 10187: second elastic member;
1019: second housing mounting bracket; 1019a: third surface; 1019b: fourth surface; 10191: third sliding groove;
101911: third sliding rail; 10192: fourth sliding groove; 101921: fourth sliding rail; 10193: second rotating slot;
1020: second support arm; 102001: third sliding block; 1021: second swing arm; 102101: second arc-shaped rotation block;
102102: fourth sliding block; 102103: second guiding structure; 1021031: second protrusion; 102104: second plugging hole;
1021041: second groove; 1022: third support arm; 1023: fourth support arm;
102: first support plate; 102a: first plate surface; 102b: second plate surface; 10201: first rotating part;
10202: first guiding part; 102021: first track slot; 1020211: first opening;
103: second support plate; 1031: second rotating part; 1032: second guiding part; 10321: second track slot;
103211: second opening;
104: display accommodation space; 105: end cover; 106: base;
1061: pin shaft; 1062: damping bracket;
1063: first arc-shaped slot; 1064: second arc-shaped slot;
2: first housing; 2a: first appearance surface; 2b: first support surface; 201: first groove;
3: second housing; 3a: second appearance surface; 3b: second support surface; 301: second groove; and
4: flexible display.

### DESCRIPTION OF EMBODIMENTS

To make the objectives, technical solutions, and advantages of this application clearer, the following further describes this application in detail with reference to accompanying drawings.

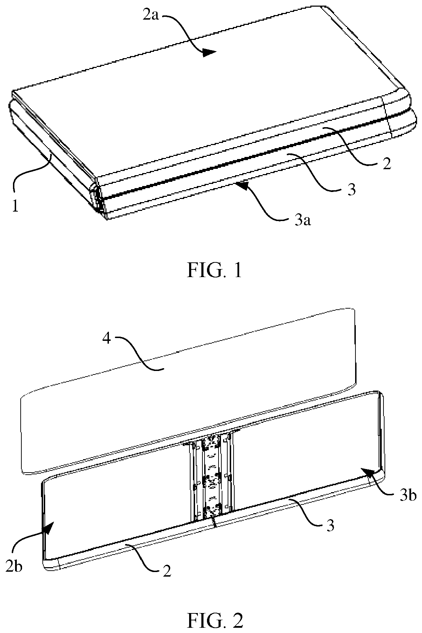

For ease of understanding a hinge mechanism provided in embodiments of this application, the following first describes an application scenario of the hinge mechanism. The hinge mechanism may be used in, but is not limited to, a foldable electronic device, for example, a mobile phone, a palmtop computer (personal digital assistant, PDA), a notebook computer, or a tablet computer. When the hinge mechanism provided in embodiments of this application is used in the electronic device, refer to FIG. 1. FIG. 1 is a schematic diagram of a structure of the electronic device according to an embodiment of this application. In addition to a hinge mechanism 1, the electronic device may further include two housings and a flexible display. For ease of description, the two housings may be respectively named as a first housing 2 and a second housing 3. The first housing 2 and the second housing 3 are located on two sides of the hinge mechanism 1 and are capable of rotating around the hinge mechanism 1. When the electronic device is used, the electronic device may be folded and unfolded in different use scenarios. The electronic device provided in this application may be an inward folding electronic device. In the embodiment shown in FIG. 1, the electronic device is in a folded state, and FIG. 1 shows a relative position relationship between the hinge mechanism 1 and the two housings when the electronic device is in the folded state. In this case, a surface of the hinge mechanism 1, a first appearance surface 2a of the first housing 2, and a second appearance surface 3a of the second housing 3 may be jointly used as an appearance surface of the electronic device. The first appearance surface 2a of the first housing 2 is a surface that is of the first housing 2 and that is away from the flexible display, and the second appearance surface 3a of the second housing 3 is a surface that is of the second housing 3 and that is away from the flexible display 4.

In addition, refer to FIG. 2. FIG. 2 is a schematic diagram of a structure of the electronic device in an unfolded state. It should be noted that FIG. 2 shows structures of a first support surface 2b of the first housing 2 and a second support surface 3b of the second housing 3. The first support surface 2b of the first housing 2 is a surface that is of the first housing 2 and that is used to support the flexible display 4, and the second support surface 3b of the second housing 3 is a surface that is of the second housing 3 and that is used to support the flexible display 4. The flexible display 4 may contiguously cover the first support surface 2b of the first housing 2, the second support surface 3b of the second housing 3, and the hinge mechanism 1, and the flexible display 4 may be fastened to the first support surface 2b of the first housing 2 and the second support surface 3b of the second housing 3. A connection mode may be, but is not limited to, bonding. In this way, when the electronic device is in the unfolded state shown in FIG. 2, the first housing 2 and the second housing 3 may support the flexible display 4.

In a process in which the first housing 2 and the second housing 3 relatively rotate from the unfolded state shown in FIG. 2 to the folded state shown in FIG. 1, or from the folded state shown in FIG. 1 to the unfolded state shown in FIG. 2, the flexible display 4 may be bent or flattened along with the first housing 2 and the second housing 3.

It may be understood that a process in which the electronic device changes from the unfolded state shown in FIG. 2 to the folded state shown in FIG. 1 or from the folded state shown in FIG. 1 to the unfolded state shown in FIG. 2 is a process in which the first housing 2 and the second housing 3 rotate around the hinge mechanism 1. As a key functional component in the foldable electronic device, the hinge mechanism 1 may be disposed corresponding to a foldable part of the flexible display 4, so that the hinge mechanism 1 supports the foldable part of the flexible display 4 in the unfolded state shown in FIG. 2, and plays an important role in accommodating the foldable part of the flexible display 4 in the folded state shown in FIG. 1.

For example, when the electronic device is in the folded state shown in FIG. 1, if space formed between the first housing 2, the hinge mechanism 1, and the second housing 3 cannot meet a bending requirement of the flexible display 4, the flexible display 4 may be squeezed or pulled. In this way, after the electronic device performs a plurality of folding operations, the flexible display 4 is easily damaged.

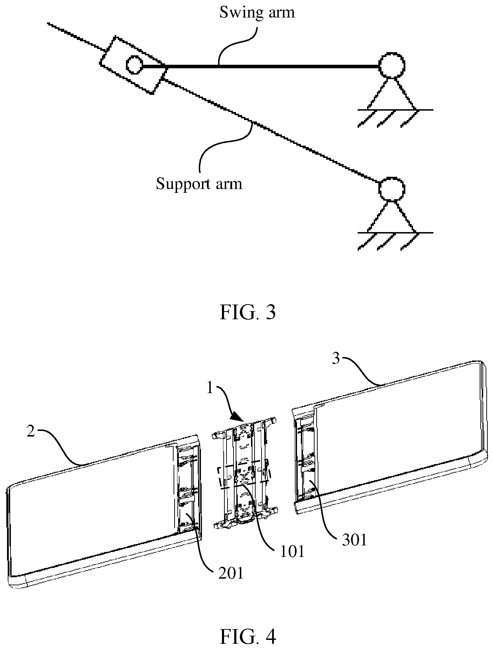

Currently, each of some existing hinge mechanisms may include a base and two rotating components during specific disposing, and each rotating component may include a support arm, a swing arm, and a housing mounting bracket. Both the support arm and the swing arm may be rotatably connected to the base, the support arm may be slidably connected to the housing mounting bracket, the swing arm may be rotatably connected to the housing mounting bracket, and the housing mounting bracket may be fastened to a housing of the electronic device. For each rotating component, in a process in which the support arm and the swing arm rotate around the base, refer to FIG. 3. FIG. 3 is a diagram of a principle of a mechanism in which the support arm and the swing arm rotate. Because axes of the support arm and the swing arm do not coincide, a phase difference exists in the process in which the support arm and the swing arm rotate around the base. In this way, in a process in which the hinge mechanism changes with the electronic device from the folded state shown in FIG. 1 to the unfolded state shown in FIG. 2, an extension length of the housing mounting bracket relative to the base increases under the push of the swing arm, and a length of the hinge mechanism increases. In a process in which the hinge mechanism changes from the unfolded state shown in FIG. 2 to the folded state shown in FIG. 1, an extension length of the housing mounting bracket relative to the base decreases under the driving of the swing arm, and a length of the hinge mechanism decreases. In the process in which the hinge mechanism rotates, the housing mounting bracket performs telescopic motion relative to the base, so that the hinge mechanism can adapt to a length of a part that is of the flexible display and that is disposed corresponding to the hinge mechanism. This avoids pulling or squeezing the flexible display.

It may be understood from the foregoing description of a motion principle of the existing hinge mechanism that the phase difference between the support arm and the swing arm plays a key role in ensuring reliability of the flexible display. Phase difference effect between the support arm and the swing arm may be implemented by designing a rotation angle of the swing arm. In a process in which the swing arm rotates around the base, to avoid interference to the rotation angle of the swing arm, a wall thickness of the swing arm or another component of the hinge mechanism generally needs to be thinned. In addition, for hinge mechanisms of a same volume, to meet reliability of structures of the hinge mechanisms, a wall thickness of each component is required. Based on this, it is very important to ensure reliability of a structure of the hinge mechanism while implementing telescopic motion in the process in which the hinge mechanism rotates to reduce a risk of damaging the flexible display.

The hinge mechanism provided in this application aims to resolve the foregoing problem, to implement the telescopic motion in the process in which the hinge mechanism rotates while ensuring the reliability of the structure of the hinge mechanism, so that the flexible display can be stably supported when the hinge mechanism is in an unfolded state, and a display accommodation space can be formed to meet the bending requirement of the flexible display when the hinge mechanism is in a folded state. This can avoid deformation of the flexible display, and reduce squeezing or pulling stress on the flexible display, to prolong a service life of the flexible display and improve reliability of the electronic device. To facilitate understanding of the hinge mechanism provided in embodiments of this application, the following describes a specific structure of the hinge mechanism in detail with reference to the accompanying drawings.

It should be noted that terms used in the following embodiments are merely intended to describe specific embodiments, but are not intended to limit this application. The terms "one", "a" and "this" of singular forms used in this specification and the appended claims of this application are also intended to include expressions such as "one or more", unless otherwise specified in the context clearly.

Reference to "an embodiment", "some embodiments", or the like described in this specification indicates that one or more embodiments of this application include a specific feature, structure, or characteristic described with reference to embodiments. Therefore, statements such as "in an embodiment", "in some embodiments", "in some other embodiments", and "in other embodiments" that appear at different places in this specification do not necessarily mean referring to a same embodiment. Instead, the statements mean "one or more but not all of embodiments", unless otherwise specifically emphasized in another manner. The terms "include", "have", and their variants all mean "include but are not limited to", unless otherwise specifically emphasized in another manner.

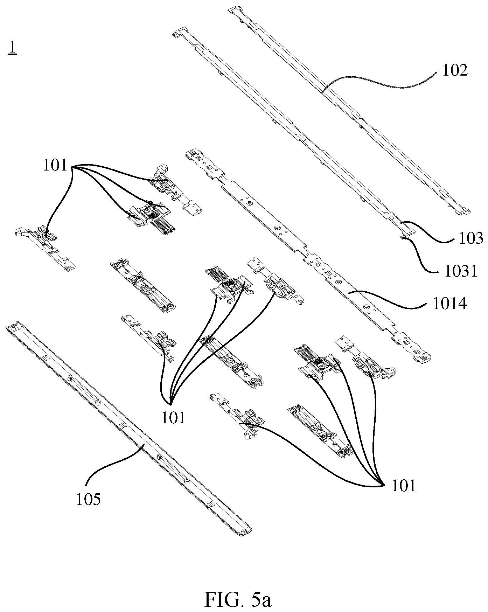

FIG. 4 is a schematic diagram of an exploded structure of the electronic device shown in FIG. 2. The flexible display is omitted in FIG. 4. In addition, it can be seen from FIG. 4 that the first housing 2 and the second housing 3 are located on the two opposite sides of the hinge mechanism 1. In this application, the hinge mechanism 1 may include one main hinge module 101, or may include a plurality of main hinge modules 101. For example, refer to FIG. 5a. FIG. 5a is a schematic diagram of an exploded structure of the hinge mechanism 1 shown in FIG. 4. In the embodiment shown in FIG. 5a, the hinge mechanism 1 includes three main hinge modules 101, and the three main hinge modules 101 may be arranged at intervals along a length direction of the hinge mechanism 1. In this application, the length direction of the hinge mechanism 1 is an extension direction of an axis of rotation of the first housing 2 and the second housing 3 around the hinge mechanism 1. The first housing 2 and the second housing 3 may be rotatably connected through the plurality of main hinge modules 101. In this way, stability of rotation of the first housing 2 and the second housing 3 of the electronic device relative to the hinge mechanism 1 can be effectively improved.

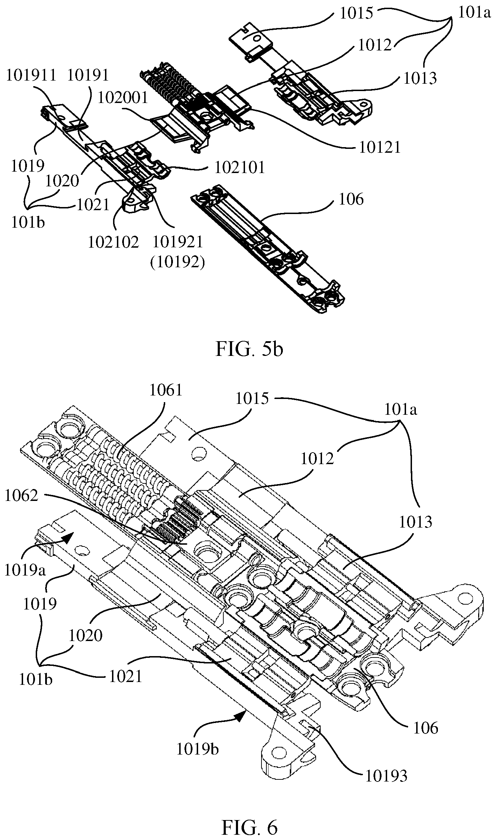

When the main hinge module 101 is specifically disposed, refer to FIG. 5b. FIG. 5b is an exploded view of a partial structure of the hinge mechanism 1 according to a possible embodiment of this application. Refer to FIG. 5a and FIG. 5b. In this application, the main hinge module 101 may include a first rotating component 101a and a second rotating component 101b.

FIG. 6 is a schematic diagram of a partial structure of the hinge mechanism 1 according to a possible embodiment of this application. In this application, the hinge mechanism 1 may further include a base 106. In addition, refer to FIG. 5b and FIG. 6. The base 106 may be used as a bearing component of the first rotating component 101a and the second rotating component 101b, and the first rotating component 101a and the second rotating component 101b are respectively disposed on two sides of the base 106. In addition, the first rotating component 101a and the second rotating component 101b may be symmetrically disposed relative to the base 106. For ease of description, in the following embodiments of this application, a specific disposing manner of the first rotating component 101a and a connection relationship between the first rotating component 101a and the base 106 are mainly used as examples to describe the main hinge module 101. The second rotating component 101b may be disposed with reference to the first rotating component 101a.

It should be noted that, in a possible embodiment of this application, when there are a plurality of main hinge modules 101, first rotating components 101a and second rotating components 101b of the plurality of main hinge modules 101 may all use a same base 106 as a bearing component, to improve an integration degree of the hinge mechanism 1. In some other possible embodiments of this application, the hinge mechanism 1 may be provided with one base 106 corresponding to each main hinge module 101, so that a first rotating component 101a and a second rotating component 101b of each main hinge module 101 use the corresponding base 106 as a bearing component.

Still refer to FIG. 6. In this application, the first rotating component 101a may include a first support arm 1012, and the first support arm 1012 may be rotatably connected to the base 106. For example, the first support arm 1012 may be rotatably connected to the base 106 through a pin shaft 1061. During specific implementation, the base 106 may be provided with a damping bracket 1062, and the pin shaft 1061 may penetrate both the damping bracket 1062 and the first support arm 1012, so that the first support arm 1012 is rotatably connected to the damping bracket 1062 through the pin shaft 1061. This implements a rotatable connection between the first support arm 1012 and the base 106.

It should be noted that, in this application, the first support arm 1012 may be rotatably connected to the damping bracket 1062 through the pin shaft 1061. In some possible embodiments, the first support arm 1012 may alternatively be rotatably connected to the damping bracket 1062 in a manner of a virtual shaft. The virtual shaft is an axis center of a circular-arc-shaped structure. Two components that are rotatably connected are capable of rotating relative to the virtual shaft, and a location of the virtual shaft is fixed as the two components that are rotatably connected rotate relative to each other. For example, an arc-shaped slot may be disposed on the damping bracket 1062, and an arc-shaped rotation block may be disposed on the first support arm 1012. In this way, rotation of the first support arm 1012 and the damping bracket 1062 is implemented by sliding the arc-shaped rotation block along a slot surface of the arc-shaped slot.

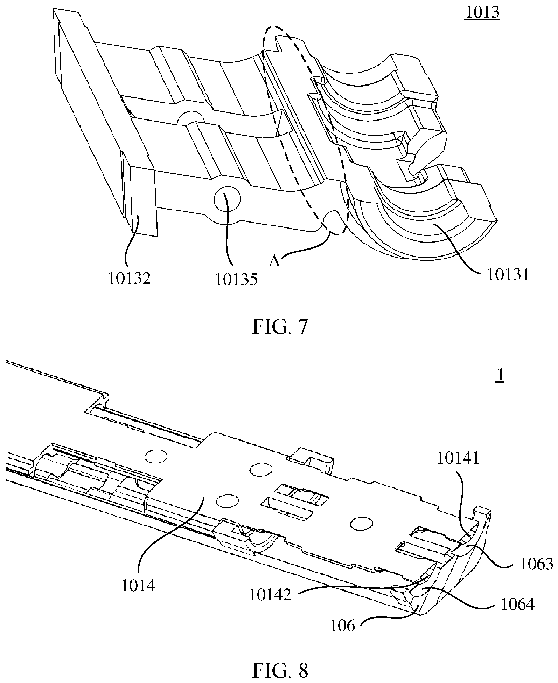

In this application, the first rotating component 101a may further include a first swing arm 1013, and the first swing arm 1013 is rotatably connected to the base 106. In a possible embodiment of this application, the first swing arm 1013 and the base 106 may be rotatably connected in the manner of the virtual shaft. For example, refer to FIG. 7. FIG. 7 is a schematic diagram of a structure of the first swing arm 1013 according to a possible embodiment of this application. A first arc-shaped rotation block 10131 may be disposed at an end that is of the first swing arm 1013 and that is used to connect to the base 106.

In addition, refer to FIG. 8. FIG. 8 is a schematic diagram of a partial structure of the hinge mechanism. The base 106 may be provided with a first arc-shaped slot 1063, and the first arc-shaped rotation block 10131 of the first swing arm 1013 shown in FIG. 7 may be accommodated in the first arc-shaped slot 1063 and is capable of rotating along an arc-shaped surface of the first arc-shaped slot 1063. In this way, the first swing arm 1013 rotates around the base 106. The first swing arm 1013 is rotatably connected to the base 106 in the manner of the virtual shaft. This can help reduce space occupied by the first swing arm 1013 on the base 106, thereby helping reduce a volume of the main hinge module 101. In this way, a compact design of the hinge mechanism 1 is implemented. It should be noted that, in this application, the first arc-shaped rotation block 10131 may be but is not limited to a circular-arc-shaped rotation block, and the first arc-shaped slot 1063 may be but is not limited to a circular-arc-shaped slot.

Still refer to FIG. 8. The hinge mechanism 1 may further include a cover plate 1014, and the cover plate 1014 may cover the base 106, to form an accommodation space between the cover plate 1014 and the base 106. It should be noted that, in this application, one cover plate 1014 may be disposed for each main hinge module 101, so that a structure is flexible. Alternatively, the plurality of main hinge modules 101 may share one cover plate 1014, to simplify a structure of the hinge mechanism 1. In addition, it can be seen from FIG. 8 that a first arc-shaped protrusion 10141 may be disposed on a surface that is of the cover plate 1014 and that faces the first arc-shaped slot 1063. In this case, the first arc-shaped rotation block 10131 of the first swing arm 1013 shown in FIG. 7 may be inserted between the first arc-shaped protrusion 10141 and the first arc-shaped slot 1063. Therefore, the first arc-shaped protrusion 10141 limits the first arc-shaped rotation block 10131 of the first swing arm 1013 to the first arc-shaped slot 1063 of the base 106, to reduce a risk that the first swing arm 1013 falls off from the base 106. This improves reliability of motion of the first swing arm 1013.

In another possible embodiment of this application, the first arc-shaped slot 1063 may alternatively be of an integrated channel structure directly disposed on the base 106. This can implement an integrated design of the base 106, and improve reliability of the structure of the hinge mechanism. In addition, a quantity of first arc-shaped slots 1063 may be but is not limited to at least two, the at least two first arc-shaped slots 1063 may be spaced apart in a length direction of the base 106, and the at least two first arc-shaped slots 1063 may limit the first arc-shaped rotation block 10131. This improves reliability of a connection between the first arc-shaped rotation block 10131 and the base 106.

In other embodiments of this application, the first swing arm 1013 may alternatively be rotatably connected to the base 106 in a manner of a physical shaft. For example, the first swing arm 1013 may be rotatably connected to the base 106 through a pin shaft. In this way, when the hinge mechanism includes the plurality of main hinge modules 101, a first swing arm 1013 of at least one main hinge module 101 in the plurality of main hinge modules 101 may be rotatably connected to the base 106 in the manner of the virtual shaft, and the first swing arm 1013 of the at least one main hinge module 101 is rotatably connected to the base 106 in the manner of the physical shaft. In this case, the first swing arm 1013 of the main hinge module 101 disposed opposite to the flexible display of the electronic device may be rotatably connected to the base 106 in the manner of the virtual shaft, and first swing arms 1013 of main hinge modules 101 located at two ends of the length direction of the hinge mechanism are rotatably connected to the base 106 in the manner of the physical shaft.

Still refer to FIG. 6. In this application, the first rotating component may further include a first housing mounting bracket 1015, and the first housing mounting bracket 1015 may be connected to the first support arm 1012 and the first swing arm 1013.

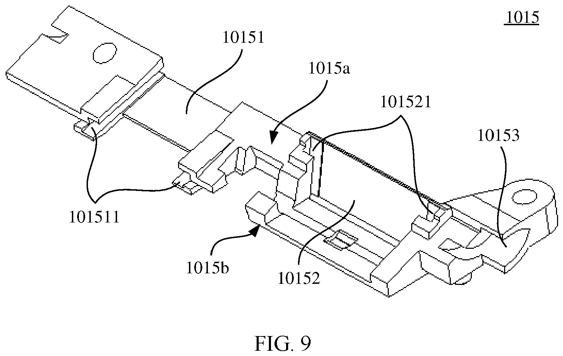

When the first housing mounting bracket 1015 is specifically disposed, refer to FIG. 9. FIG. 9 is a schematic diagram of a structure of the first housing mounting bracket 1015 according to a possible embodiment of this application. In this embodiment, a first sliding groove 10151 may be disposed on the first housing mounting bracket 1015, and the first sliding groove 10151 extends in a first direction. Refer to FIG. 6 and FIG. 9. The first support arm 1012 may be mounted in the first sliding groove 10151 and is capable of sliding in the first sliding groove 10151. The first direction may be a direction in which the first housing mounting bracket 1015 moves toward or away from the base 106. In addition, to prevent the first support arm 1012 from falling off from the first sliding groove 10151, a first sliding rail 101511 may be disposed on a groove wall of the first sliding groove 10151, and a first sliding block 10121 may be disposed on the first support arm 1012 (refer to FIG. 5b). In this way, the first sliding block 10121 may be clamped in the first sliding rail 101511, and the first sliding block 10121 is capable of sliding along the first sliding rail 101511, to limit the first support arm 1012 in the first sliding groove 10151. In addition, the first sliding rail 101511 is disposed on the groove wall of the first sliding groove 10151. This can provide guidance for sliding of the first support arm 1012 along the first sliding groove 10151, thereby improving stability of motion of the first support arm 1012.

Still refer to FIG. 9. A second sliding groove 10152 may further be disposed on the first housing mounting bracket 1015. The second sliding groove 10152 may extend in a second direction, and the first sliding groove 10151 and the second sliding groove 10152 are spaced apart in a length direction of the first housing mounting bracket 1015. Refer to FIG. 7 and FIG. 9. An end that is of the first swing arm 1013 and that faces the first housing mounting bracket 1015 may be mounted in the second sliding groove 10152, and the first swing arm 1013 is capable of sliding in the second sliding groove 10152. It should be noted that, in this application, the first housing mounting bracket 1015 may include a first surface 1015a and a second surface 1015b that are disposed opposite to each other. When the hinge mechanism 1 is used in the electronic device, the first surface 1015a may be a surface of a side that is of the first housing mounting bracket 1015 and that faces the flexible display. The second direction may be a direction from the first surface 1015a to the second surface 1015b, or a direction from the second surface 1015b to the first surface 1015a. In addition, a projection in the second direction in a first cross section may not be parallel to a projection in the first direction in the first cross section. The first cross section may be a reference plane perpendicular to a rotation axis of the first support arm 1012 and a rotation axis of the first swing arm 1013.

In addition, still refer to FIG. 9. In this application, a second sliding rail 101521 may be disposed in the second sliding groove 10152, and a second sliding block 10132 may be disposed on the first swing arm 1013 shown in FIG. 7. In this way, the second sliding block 10132 may be clamped in the second sliding rail 101521, and the second sliding block 10132 is capable of sliding in the second sliding rail 101521 in the second direction, to limit the first swing arm 1013 in the second sliding groove 10152. Therefore, the first swing arm 1013 can be prevented from falling off from the second sliding groove 10152. In addition, the second sliding rail 101521 is disposed on a groove wall of the second sliding groove 10152. This can provide guidance for sliding of the first swing arm 1013 along the second sliding groove 10152, thereby improving stability of motion of the first swing arm 1013.

It can be learned from the foregoing description that, in this application, the second rotating component 101b and the first rotating component 101a may be symmetrically disposed relative to the base 106. During specific implementation, refer to FIG. 5b and FIG. 6. The second rotating component 101b may include a second housing mounting bracket 1019, a second support arm 1020, and a second swing arm 1021. The second housing mounting bracket 1019 has a third surface 1019a and a fourth surface 1019b that are disposed opposite to each other. When the hinge mechanism is used in the electronic device, the third surface 1019a is a surface of a side that is of the second housing mounting bracket 1019 and that faces the flexible display. In addition, the second housing mounting bracket 1019 may include a third sliding groove 10191 extending in a third direction and a fourth sliding groove 10192 extending in a fourth direction. The second support arm 1020 is capable of sliding in the third sliding groove 10191, and the second swing arm 1021 is capable of sliding in the fourth sliding groove 10192. A projection in the third direction in a second cross section is not parallel to a projection in the fourth direction in the second cross section. The second cross section is a reference plane perpendicular to a rotation axis of the second support arm 1020 and a rotation axis of the second swing arm 1021.

In addition, still refer to FIG. 5b. A third sliding rail 101911 may be disposed on the third sliding groove 10191, a third sliding block 102001 may be disposed on the second support arm 1020, a fourth sliding rail 101921 may be disposed on the fourth sliding groove 10192, and a fourth sliding block 102102 may be disposed on the second swing arm 1021. For a disposing manner of the third sliding rail 101911, refer to the first sliding rail 101511. For a disposing manner of the third sliding block 102001, refer to the first sliding block 10121. For a disposing manner of the fourth sliding rail 101921, refer to the second sliding rail 101521. For a disposing manner of the fourth sliding block 102102, refer to the second sliding block 10132. Details are not described herein again.

In this application, the second swing arm 1021 may be disposed with reference to the first swing arm 1013 shown in FIG. 7. To implement a rotatable connection between the second swing arm 1021 and the base 106, refer to FIG. 8. The base 106 includes a second arc-shaped slot 1064, and the second swing arm 1021 is provided with a second arc-shaped rotation block 102101 (refer to FIG. 5b). In addition, still refer to FIG. 8. A second arc-shaped protrusion 10142 may further be disposed on a surface that is of the cover plate 1014 and that faces the second arc-shaped slot 1064. The second arc-shaped slot 1064 may be disposed with reference to the first arc-shaped slot 1063, the second arc-shaped rotation block 102101 may be disposed with reference to the first arc-shaped rotation block 10131, and the second arc-shaped protrusion 10142 may be disposed with reference to the first arc-shaped protrusion 10141. Details are not described herein again.

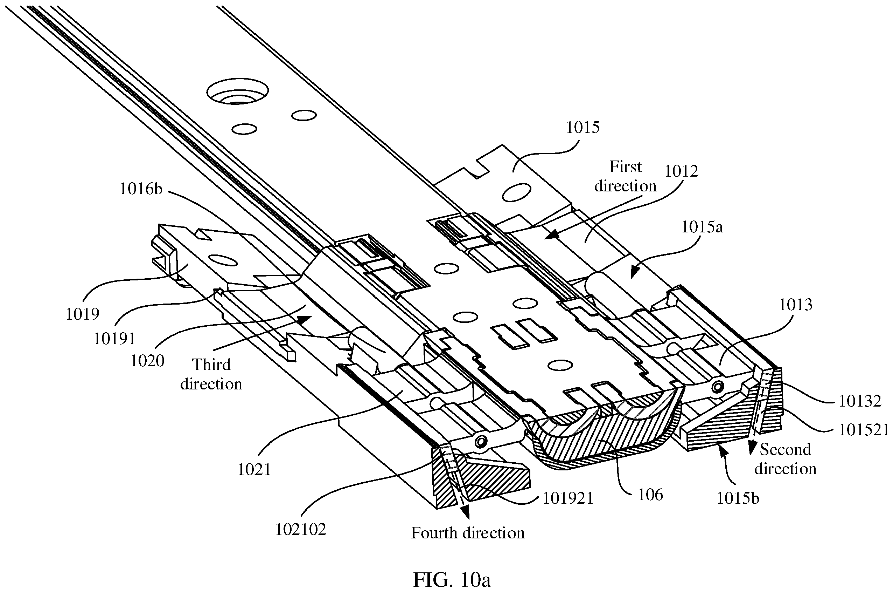

After a connection relationship between the first rotating component 101a and the second rotating component 101b and the base 106 provided in the foregoing embodiment of this application is understood, motion of the hinge mechanism is described below. First, refer to FIG. 10a. FIG. 10a is a schematic diagram of a structure of the hinge mechanism in an unfolded state. In this case, a distance between the base 106 and an edge that is of the first housing mounting bracket 1015 and that faces the base 106 is the closest, and a distance between the second sliding block 10132 of the first swing arm 1013 and the first surface 1015a of the first housing mounting bracket 1015 is the closest.

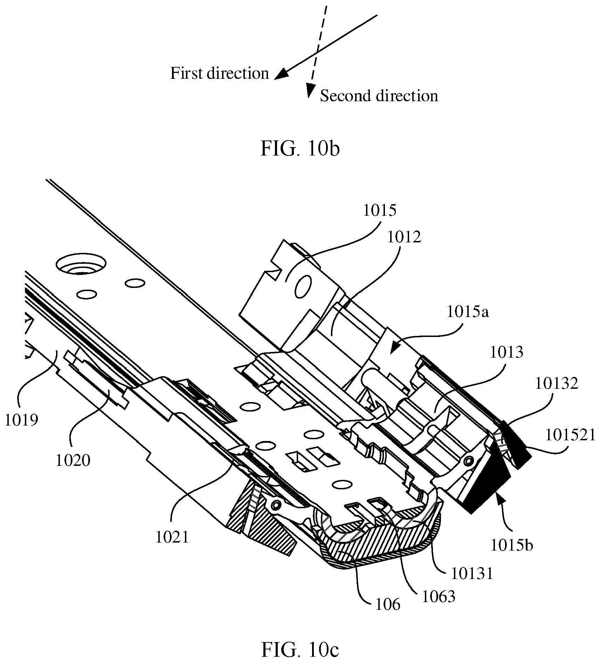

It can be learned from the description of the foregoing embodiment that, when the hinge mechanism rotates from the unfolded state to a folded state, the first support arm 1012 is capable of sliding in the first sliding groove 10151 in the first direction, and the first swing arm 1013 is capable of sliding in the second sliding groove 10152 in the second direction. Similarly, the second support arm 1020 is capable of sliding in the third sliding groove 10191 in the third direction, and the second swing arm 1021 is capable of sliding in the fourth sliding groove 10192 in the fourth direction. In FIG. 10a, the first direction and the third direction are respectively indicated by solid lines with arrows, and the second direction and the fourth direction are respectively indicated by dotted lines with arrows. In addition, refer to FIG. 10b. FIG. 10b is a schematic diagram of the first cross section according to a possible embodiment. In the first cross section, the first direction and the second direction intersect, and an angle at which the first direction and the second direction intersect may be an acute angle in the figure, or may be another possible angle, for example, a right angle or an obtuse angle. In addition, in the second cross section, a position relationship between the third direction and the fourth direction may be symmetric with a position relationship between the first direction and the second direction shown in FIG. 10b. Details are not described herein again.

FIG. 10c is a schematic diagram of a structure of the hinge mechanism in an intermediate state. Compared with FIG. 10c and FIG. 10a, it can be learned that, in this process, the first housing mounting bracket 1015 may move relative to the first support arm 1012 in a direction away from the base 106, and drive the first support arm 1012 and the first swing arm 1013 to rotate around the base 106. The first arc-shaped rotation block 10131 of the first swing arm 1013 moves in a direction of sliding out of the corresponding first arc-shaped slot 1063, so that a part that is of the first arc-shaped rotation block 10131 and that is accommodated in the corresponding first arc-shaped slot 1063 is reduced. At the same time, the second sliding block 10132 of the first swing arm 1013 slides in the second sliding rail 101521 from the first surface 1015a of the first housing mounting bracket 1015 to the second surface 1015b. Similarly, the second housing mounting bracket 1019 may drive the second support arm 1020 and the second swing arm 1021 to rotate around the base. A specific motion process is similar to a motion process in which the first housing mounting bracket 1015 drives the first support arm 1012 and the first swing arm 1013 to rotate around the base 106. Details are not described herein again.

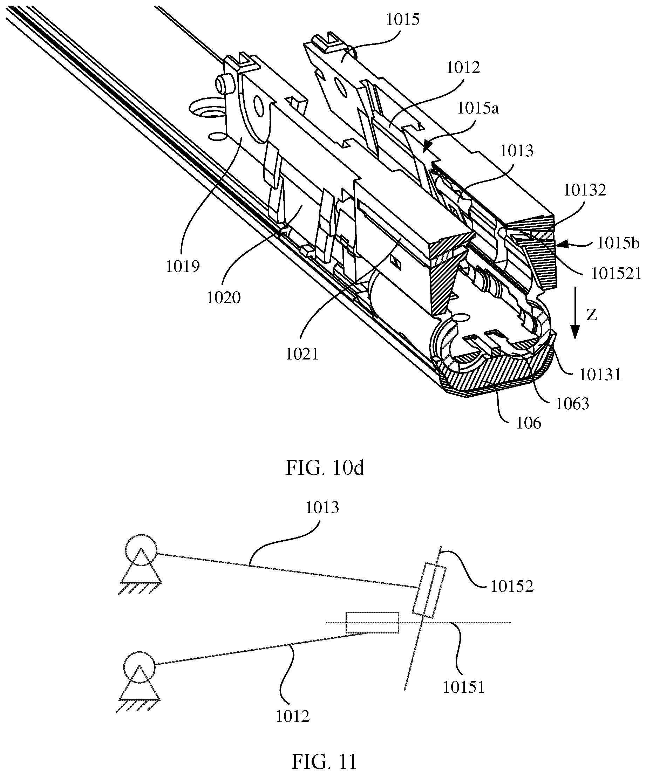

In addition, refer to FIG. 10d. FIG. 10d is a schematic diagram of a structure of the hinge mechanism in the folded state. In a process from FIG. 10c to FIG. 10d, the first housing mounting bracket 1015 continues to move relative to the first support arm 1012 in the direction away from the base 106, and drives the first support arm 1012 to rotate around the base 106. The first arc-shaped rotation block 10131 of the first swing arm 1013 continues to move in the direction of sliding out of the corresponding first arc-shaped slot 1063, so that the part that is of the first arc-shaped rotation block 10131 and that is accommodated in the corresponding first arc-shaped slot 1063 is further reduced. At the same time, the second sliding block 10132 of the first swing arm 1013 continues to slide in the second sliding groove 10152 toward the second surface 1015b of the first housing mounting bracket 1015. Similarly, the second housing mounting bracket 1019 may drive the second support arm 1020 and the second swing arm 1021 to continue to rotate around the base. A specific motion process is similar to the motion process in which the first housing mounting bracket 1015 drives the first support arm 1012 and the first swing arm 1013 to rotate around the base 106. Details are not described herein again.

It may be understood that, when the electronic device rotates from the folded state shown in FIG. 10d to the unfolded state shown in FIG. 10a, the first housing mounting bracket 1015, the first support arm 1012, the first swing arm 1013, the second housing mounting bracket 1019, the second support arm 1020, and the second swing arm 1021 may separately move in a direction opposite to the foregoing rotation process from FIG. 10a to FIG. 10d. Details are not described herein again.

FIG. 11 is a diagram of a principle of a mechanism in which the first support arm 1012 and the first swing arm 1013 slide relative to the first housing mounting bracket 1015 according to an embodiment of this application. It can be seen from FIG. 11 that, the hinge mechanism 1 provided in this application is used, so that rotation axis centers of the first support arm 1012 and the first swing arm 1013 do not coincide when the first support arm 1012 and the first swing arm 1013 rotate around the base 106. In this way, an axis center phase difference between the first support arm 1012 and the first swing arm 1013 can be implemented. In addition, disposing directions of the first sliding groove 10151 and the second sliding groove 10152 are properly designed, so that neither of angles at which the first support arm 1012 and the first swing arm 1013 rotate relative to the base 106 may be greater than 90°. Compared with that in an existing solution, a rotation angle of the first swing arm 1013 can be effectively reduced. In this way, a wall thickness design of a local structure (for example, a structure at a position A of the first swing arm 1013 shown in FIG. 7) of the first swing arm 1013 can meet a strength requirement. This improves reliability of a structure of the first swing arm 1013. It may be understood that FIG. 11 may also be used to show a principle of a mechanism in which the second support arm 1020 and the second swing arm 1021 slide relative to the second housing mounting bracket 1019. It can be learned from the foregoing analysis that, in this application, disposing directions of the third sliding groove 10191 and the fourth sliding groove 10192 are properly designed, so that neither of angles at which the second support arm 1020 and the second swing arm 1021 rotate relative to the base 106 is greater than 90°. Therefore, a rotation angle of the second swing arm 1021 is reduced. In this way, a wall thickness design of a local structure of the second swing arm 1021 meets a strength requirement. This improves reliability of a structure of the second swing arm 1021. In addition, when the hinge mechanism 1 is used in the electronic device, a thinning design for a component in the electronic device can be effectively avoided, to avoid rotation of the first swing arm 1013 and the second swing arm 1021. This can improve reliability of an overall structure of the electronic device.

In addition, still refer to FIG. 10d. When the hinge mechanism is in the folded state, both the first support arm 1012 and the first swing arm 1013 have supporting force for the first housing mounting bracket 1015 in a Z direction shown in FIG. 10d. This can effectively improve degrees of motion bonding between the first support arm 1012 and the first swing arm 1013 and the first housing mounting bracket 1015, and play a stop role in the first housing mounting bracket 1015 in this direction. Similarly, the second support arm 1020 and the second swing arm 1021 may also have supporting force for the second housing mounting bracket 1019 in the Z direction. This can effectively improve degrees of motion bonding between the second support arm 1020 and the second swing arm 1021 and the second housing mounting bracket 1019, and play a stop role in the second housing mounting bracket 1019 in this direction. In this way, even if the electronic device in which the hinge mechanism is used falls in the folded state, a risk of generating large instantaneous displacements by the first housing mounting bracket 1015 and the second housing mounting bracket 1019 relative to the hinge mechanism in this state can be effectively reduced. This can ensure the reliability of the overall structure of the electronic device.

In this application, the second sliding block 10132 of the first swing arm 1013 may be a straight-line sliding block shown in FIG. 7. In this case, the second sliding rail 101521 may also be adaptively disposed as a straight-line sliding rail shown in FIG. 10a. In addition, the straight-line sliding rail has an opening located on the first surface 1015a. When the hinge mechanism is in the unfolded state shown in FIG. 10a, the straight-line sliding rail extends from the opening to the base 106, to improve smoothness of sliding of the second sliding block 10132 along the second sliding rail 101521. In addition, interference caused by the another structure of the hinge mechanism to the first swing arm 1013 may be reduced, to help increase a wall thickness of the first swing arm 1013, so as to improve the reliability of the structure of the first swing arm 1013. In some other possible implementations of this application, the straight-line sliding rail may alternatively extend from the opening to a direction away from the base, or the straight-line sliding rail may extend from the opening to a direction perpendicular to the second surface 1015b. In this way, the second sliding rail 101521 is disposed flexibly. It should be noted that, in this application, the second sliding block 10132 herein may alternatively be in another shape that adapts to the straight-line sliding rail, for example, may be a sliding block in an overall straight-line form with a hollow and spacing design in a middle part, or may be some specially shaped sliding blocks, as long as the sliding block can fit the sliding rail in the straight-line form for sliding.

In this application, the fourth sliding rail 101921 and the second sliding rail 101521 may be symmetrically disposed. For a specific disposing manner of the fourth sliding rail 101921, refer to the second sliding rail 101521. Details are not described herein again. In addition, the fourth sliding block 102102 may be a straight-line sliding block, or may be in another shape that adapts to a straight-line sliding rail, for example, may be a sliding block in an overall straight-line form with a hollow and spacing design in a middle part, or may be some specially shaped sliding blocks, as long as the sliding block can fit the sliding rail in the straight-line form for sliding.

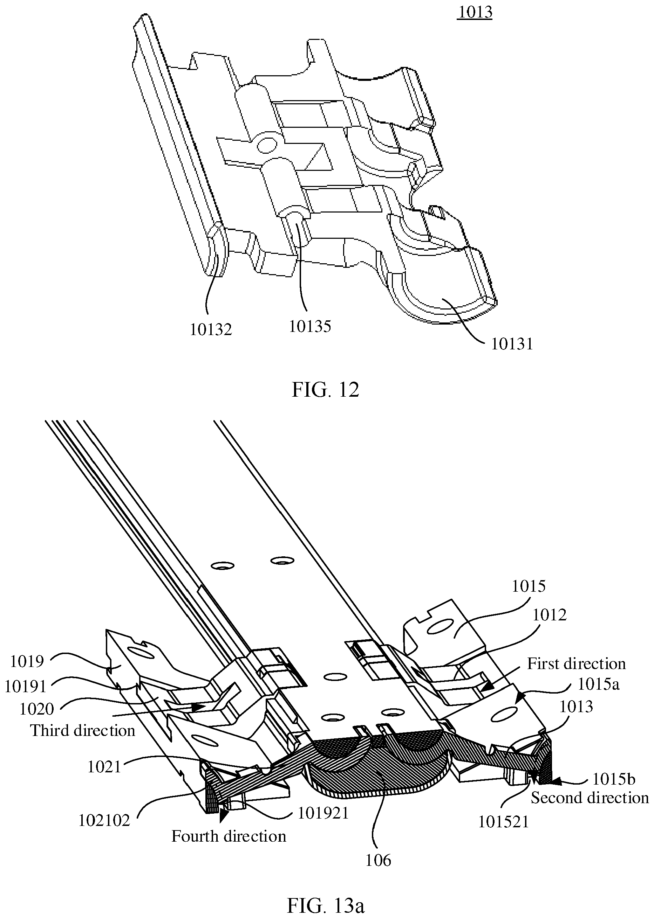

In addition to the foregoing straight-line structure, the second sliding block 10132 of the first swing arm 1013 may be designed as another possible structure. For example, refer to FIG. 12. FIG. 12 is a schematic diagram of a structure of the first swing arm 1013 according to another possible embodiment of this application. In this embodiment, the second sliding block 10132 of the first swing arm 1013 may alternatively be designed as an arc-shaped sliding block, and the arc-shaped sliding block may be, for example, a circular-arc-shaped sliding block. In addition, to enable the arc-shaped sliding block of the first swing arm 1013 to slide in the second sliding rail 101521 of the second sliding groove 10152 of the first housing mounting bracket 1015, the second sliding rail 101521 may also be designed as an arc-shaped sliding rail from the straight-line sliding rail shown in FIG. 10a. The arc-shaped sliding rail may be, for example, a circular-arc-shaped sliding rail. When the hinge mechanism is in the unfolded state, an axis center of the arc-shaped sliding rail is located on a side that is of the arc-shaped sliding rail and that is away from the base 106. This can help improve smoothness of sliding of the second sliding block 10132 along the second sliding rail 101521, and an angle at which the first swing arm 1013 rotates relative to the base 106 may be 90°, to effectively reduce interference of the another structure of the hinge mechanism to the motion of the first swing arm 1013. Therefore, the wall thickness of the first swing arm 1013 can be increased. In addition, FIG. 12 may also show a structure of the second swing arm 1021. For a specific disposing manner of the second swing arm 1021, refer to the foregoing description of the first swing arm 1013. Details are not described herein again.

In this embodiment, sliding of the first swing arm 1013 in the second sliding groove 10152 and sliding of the second swing arm 1021 in the fourth sliding groove 10192 are sliding of arc-shaped sliding blocks in arc-shaped sliding rail s. During specific implementation, first refer to FIG. 13a. FIG. 13a is a schematic diagram of a structure of the hinge mechanism in the unfolded state. In this case, the distance between the base 106 and the edge that is of the first housing mounting bracket 1015 and that faces the base 106 is the closest, and the distance between the second sliding block 10132 of the first swing arm 1013 and the first surface 1015a of the first housing mounting bracket 1015 is the closest.

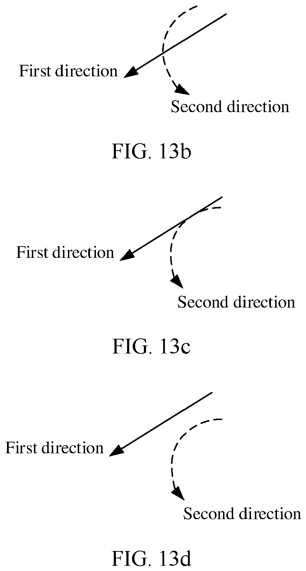

It can be learned from the description of the foregoing embodiment that, when the hinge mechanism rotates from the unfolded state to the folded state, the first support arm 1012 is capable of sliding in the first sliding groove 10151 in the first direction, and the first support arm 1012 is capable of sliding in the second sliding groove 10152 in the second direction. Similarly, the second support arm 1020 is capable of sliding in the third sliding groove 10191 in the third direction, and the second swing arm 1021 is capable of sliding in the fourth sliding groove 10192 in the fourth direction. In FIG. 13a, the first direction and the third direction are respectively indicated by solid lines with arrows, and the second direction and the fourth direction are respectively indicated by dotted lines with arrows. In addition, refer to FIG. 13b. FIG. 13b is a schematic diagram of the first cross section according to a possible embodiment. In the first cross section, the first direction and the second direction intersect. In addition, in the second cross section, a position relationship between the third direction and the fourth direction may be symmetric with a position relationship between the first direction and the second direction shown in FIG. 13b. Details are not described herein again.

It should be noted that, in this application, the projection in the second direction in the first cross section is not parallel to the projection in the first direction in the first cross section, and the projection in the fourth direction in the second cross section is not parallel to the projection in the third direction in the second cross section. In addition to intersection between the first direction and the second direction shown in FIG. 10b and FIG. 13b, a tangent relationship between the first direction and the second direction shown in FIG. 13c or a separation relationship between the first direction and the second direction shown in FIG. 13d may exist. This is not specifically limited in this application.

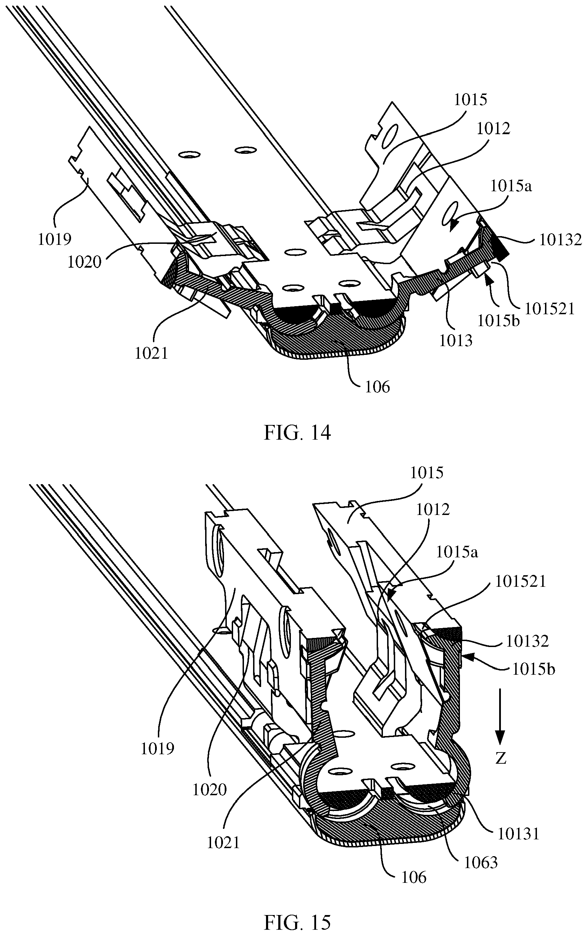

In a process in which the hinge mechanism rotates from the unfolded state to the folded state, the first support arm 1012 is capable of sliding in the first sliding groove along the first direction shown in FIG. 13a, and the first swing arm 1013 is capable of sliding in the second sliding groove along the second direction shown in FIG. 13a. In addition, refer to FIG. 14. FIG. 14 is a schematic diagram of a structure of the hinge mechanism in the intermediate state. Compared with FIG. 14 and FIG. 13a, it can be learned that, in this process, the first housing mounting bracket 1015 may move relative to the first support arm 1012 in the direction away from the base 106, and drive the first support arm 1012 and the first swing arm 1013 to rotate around the base 106. The first arc-shaped rotation block 10131 of the first swing arm 1013 moves in the direction of sliding out of the corresponding first arc-shaped slot 1063, so that the part that is of the first arc-shaped rotation block 10131 and that is accommodated in the corresponding first arc-shaped slot 1063 is reduced. At the same time, the second sliding block 10132 of the first swing arm 1013 slides in the second sliding rail 101521 from the first surface 1015a of the first housing mounting bracket 1015 to the second surface 1015b. Similarly, the second housing mounting bracket 1019 may drive the second support arm 1020 and the second swing arm 1021 to rotate around the base. A specific motion process is similar to the motion process in which the first housing mounting bracket 1015 drives the first support arm 1012 and the first swing arm 1013 to rotate around the base 106. Details are not described herein again.

In addition, refer to FIG. 15. FIG. 15 is a schematic diagram of a structure of the hinge mechanism in the folded state. In a process from FIG. 14 to FIG. 15, the first housing mounting bracket 1015 continues to move relative to the first support arm 1012 in the direction away from the base 106, and drives the first support arm 1012 and the first swing arm 1013 to continue to rotate around the base 106. The first arc-shaped rotation block 10131 of the first swing arm 1013 continues to move in the direction of sliding out of the corresponding first arc-shaped slot 1063, so that the part that is of the first arc-shaped rotation block 10131 and that is accommodated in the corresponding first arc-shaped slot 1063 is further reduced. At the same time, the second sliding block 10132 of the first swing arm 1013 continues to slide in the second sliding rail 101521 toward the second surface 1015b of the first housing mounting bracket 1015. Similarly, the second housing mounting bracket 1019 may drive the second support arm 1020 and the second swing arm 1021 to continue to rotate around the base. A specific motion process is similar to the motion process in which the first housing mounting bracket 1015 drives the first support arm 1012 and the first swing arm 1013 to rotate around the base 106. Details are not described herein again.

It may be understood that, when the hinge mechanism rotates from the folded state shown in FIG. 15 to the unfolded state shown in FIG. 13a, the first housing mounting bracket 1015, the first support arm 1012, the first swing arm 1013, the second housing mounting bracket 1019, the second support arm 1020, and the second swing arm 1021 may separately move in a direction opposite to the foregoing rotation process from FIG. 13a to FIG. 15. Details are not described herein again.

In some other possible embodiments of this application, when the hinge mechanism is in the unfolded state, the axis center of the arc-shaped sliding rail may alternatively be located on a side that is of the arc-shaped sliding rail and that faces the base 106. In this way, in a process in which the hinge mechanism rotates from the unfolded state to the folded state, the second sliding block 10132 of the first swing arm 1013 slides in the second sliding rail 101521 from the second surface 1015b of the first housing mounting bracket 1015 to the first surface 1015a. In a process in which the hinge mechanism rotates from the folded state to the unfolded state, the second sliding block 10132 of the first swing arm 1013 slides in the second sliding rail 101521 from the first surface 1015a of the first housing mounting bracket 1015 to the second surface 1015b.

It should be noted that, in this application, when the second sliding rail 101521 is the arc-shaped sliding rail, the second sliding block 10132 may alternatively be in another shape that adapts to the arc-shaped sliding rail, for example, may be a sliding block in an overall arc-shaped form with a hollow and spacing design in a middle part, or may be some specially shaped sliding blocks, as long as the sliding block can fit the sliding rail in the arc-shaped form for sliding. In addition, when the second sliding rail 101521 is the circular-arc-shaped sliding rail, sliding of the second sliding block 10132 in the second sliding rail 101521 may also be understood as rotation of the second sliding block 10132 around the first housing mounting bracket 1015 through the circular-arc-shaped sliding rail.

In this application, the fourth sliding rail 101921 and the second sliding rail 101521 may be symmetrically disposed. For the specific disposing manner of the fourth sliding rail 101921, refer to the second sliding rail 101521. Details are not described herein again. In addition, the fourth sliding block 102102 may be an arc-shaped sliding block, or may be in another shape that adapts to the arc-shaped sliding rail, for example, may be a sliding block in an overall arc-shaped form with a hollow and spacing design in a middle part, or may be some specially shaped sliding blocks, as long as the sliding block can fit the sliding rail in the arc-shaped form for sliding. In addition, when the fourth sliding rail 101921 is a circular-arc-shaped sliding rail, sliding of the fourth sliding block 102102 in the fourth sliding rail 101921 may also be understood as rotation of the fourth sliding block 102102 around the second housing mounting bracket 1019 through the circular-arc-shaped sliding rail.

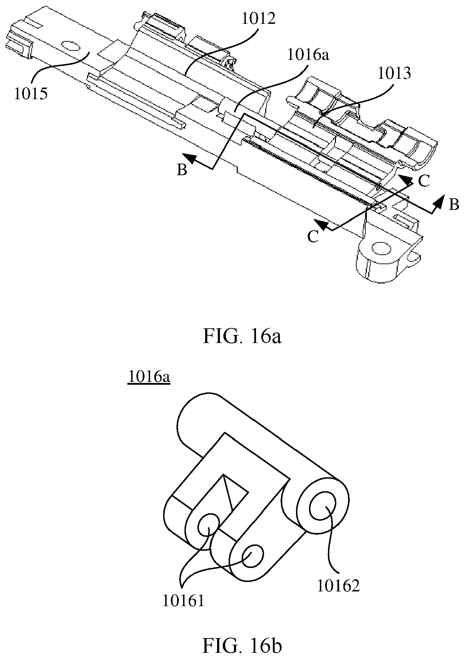

In embodiments of this application, to improve consistency and smoothness of motion of the first support arm 1012 and the first swing arm 1013 that are located on a same side, and degrees of bonding between the first support arm 1012 and the first swing arm 1013 and the corresponding sliding grooves, refer to FIG. 16a. FIG. 16a is a schematic diagram of a structure in which the first support arm 1012 is connected to the first swing arm 1013 according to an embodiment of this application. A first drive connecting rod 1016a may be disposed between the first support arm 1012 and the first swing arm 1013, and the first drive connecting rod 1016a may be separately rotatably connected to the first support arm 1012 and the first swing arm 1013. During specific implementation, refer to FIG. 16b. FIG. 16b is a schematic diagram of a structure of the first drive connecting rod 1016a according to a possible embodiment of this application. The first drive connecting rod 1016a may include a first connection part 10161 and a second connection part 10162.

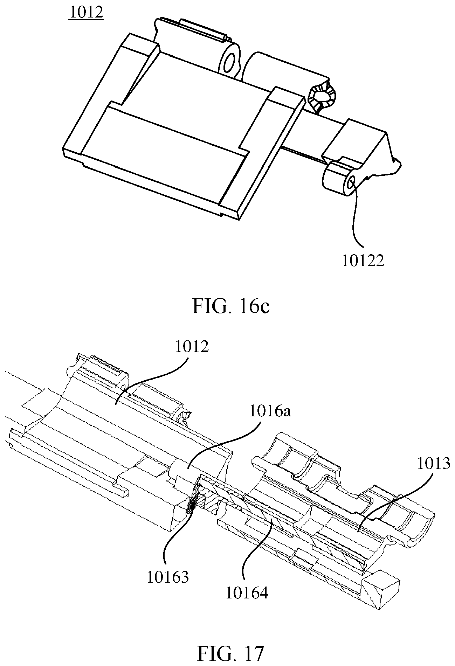

FIG. 16c is a schematic diagram of a structure of the first support arm 1012 according to a possible embodiment of this application. Refer to FIG. 16b and FIG. 16c. In this application, the first connection part 10161 of the first drive connecting rod 1016a may be connected to a first mounting hole 10122 of the first support arm 1012. The second connection part 10162 of the first drive connecting rod 1016a may be connected to a second mounting hole 10135 that is of the first swing arm 1013 and that is shown in FIG. 7 or FIG. 12.

In addition, refer to FIG. 17. FIG. 17 is a sectional view at a position B-B of the structure shown in FIG. 16a. Refer to FIG. 16b and FIG. 16c. The first connection part 10161 is rotatably connected to the first support arm 1012 through a first connecting rod 10163, and the second connection part 10162 is rotatably connected to the swing arm 1013 through a second connecting rod 10164. It should be noted that axes of the first connecting rod 10163 and the second connecting rod 10164 do not coincide to reduce a risk of interference to respective motion of the first support arm 1012 and the first swing arm 1013.

The first drive connecting rod 1016a is disposed between the first support arm 1012 and the first swing arm 1013, so that the first support arm 1012, the first swing arm 1013 and the first drive connecting rod 1016a jointly support the first housing mounting bracket 1015 when the hinge mechanism is in the folded state, to effectively improve the degrees of motion bonding between the first support arm 1012 and the first swing arm 1013 and the first housing mounting bracket 1015, and play a stop role in the first housing mounting bracket 1015. In this way, even if the electronic device in which the hinge mechanism is used falls in the folded state, a risk of generating a large instantaneous displacement by the first housing mounting bracket 1015 relative to the hinge mechanism in this state can be effectively reduced. This can ensure the reliability of the overall structure of the electronic device.

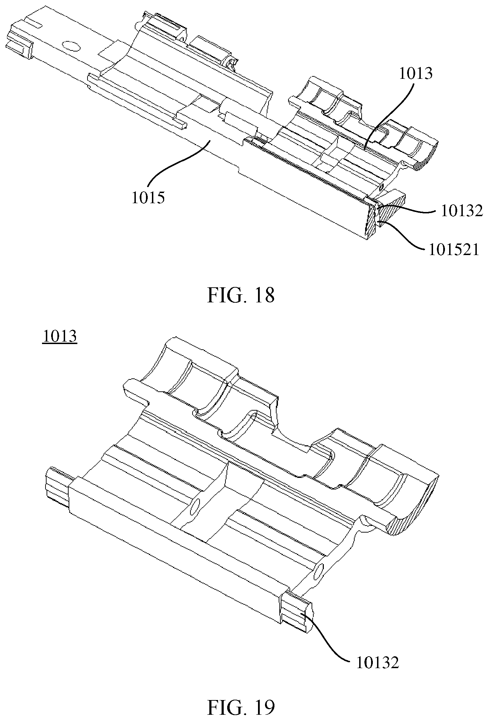

To avoid over-constraints caused by disposing of the first drive connecting rod 1016a to motion of the first support arm 1012 and the first swing arm 1013, refer to FIG. 18. FIG. 18 is a sectional view at a position C-C in FIG. 16a. In this embodiment, the second sliding block 10132 of the first swing arm 1013 may be thinned, so that the second sliding block 10132 of the first swing arm 1013 may be in clearance fit with the second sliding rail 101521 of the first housing mounting bracket 1015. During specific implementation, refer to FIG. 19. FIG. 19 is a schematic diagram of a structure of the first swing arm 1013 according to another possible embodiment. In this embodiment, a thickness of the second sliding block 10132 of the first swing arm 1013 is reduced, so that there is a gap between the second sliding block 10132 and a side wall of the second sliding rail 101521 shown in FIG. 18. In this case, a shape of the second sliding block 10132 may match a shape of the second sliding rail 101521. For example, when the second sliding rail 101521 is a rectangular sliding rail, the second sliding block 10132 may be disposed as a rectangular sliding block. Alternatively, the second sliding block 10132 may be disposed as a pin shaft, so that the second sliding block 10132 can rotate relative to the second sliding rail 101521 while sliding in the second sliding rail 101521. Therefore, in a process in which the second sliding block 10132 slides along the second sliding rail 101521, reliability of cooperation between the first swing arm 1013 and the second sliding groove 10152 of the first housing mounting bracket 1015 can be considered while a degree of freedom of the motion of the first swing arm 1013 is increased.

It should be noted that, in the foregoing embodiment, the first drive connecting rod 1016a is rotatably connected to the first support arm 1012 through the first connecting rod 10163, and is rotatably connected to the first swing arm 1013 through the second connecting rod 10164. In this way, the first support arm 1012, the first connecting rod 10163, the first swing arm 1013, and the second connecting rod 10164 can form a four-connecting rod mechanism. It may be understood that, rod lengths between structures in the four-connecting rod mechanism are adjusted, so that the formed four-connecting rod structure can be in a parallelogram or a non-parallelogram.

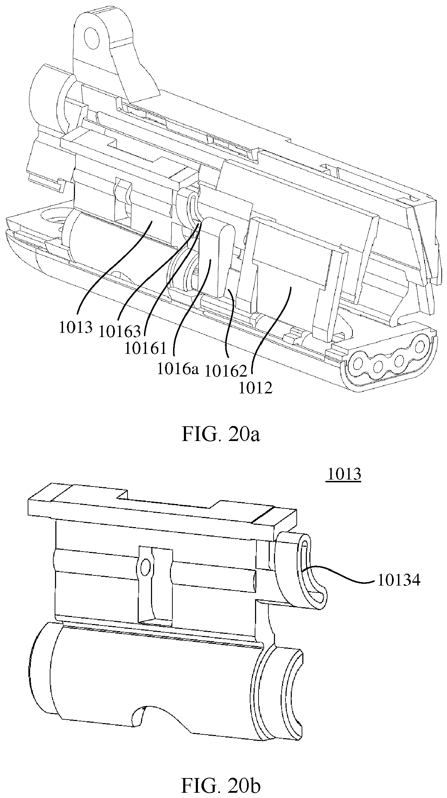

In addition, in addition to the disposing manner of the first drive connecting rod 1016a provided in the foregoing embodiment, refer to FIG. 20a. FIG. 20a is a schematic diagram of a structure in which the first support arm 1012 is connected to the first swing arm 1013 according to another embodiment of this application. In this embodiment, the first drive connecting rod 1016a is also located between the first support arm 1012 and the first swing arm 1013. Different from the foregoing embodiment, in this embodiment, the first connection part 10161 of the first drive connecting rod 1016a is slidably connected to the first swing arm 1013 through the first connecting rod 10163, and the second connection part 10162 is fastened to the first support arm 1012.

FIG. 20b is a schematic diagram of a structure of the first swing arm according to another possible embodiment of this application. Refer to FIG. 20a and FIG. 20b. A first guiding slot 10134 may be disposed at an end that is of the first swing arm 1013 and that faces the first support arm 1012, and the first connecting rod 10163 may be inserted into the first guiding slot 10134 and is capable of sliding along a slot surface of the first guiding slot 10134. Therefore, a slidable connection between the first connecting rod 10163 and the first swing arm 1013 is implemented.

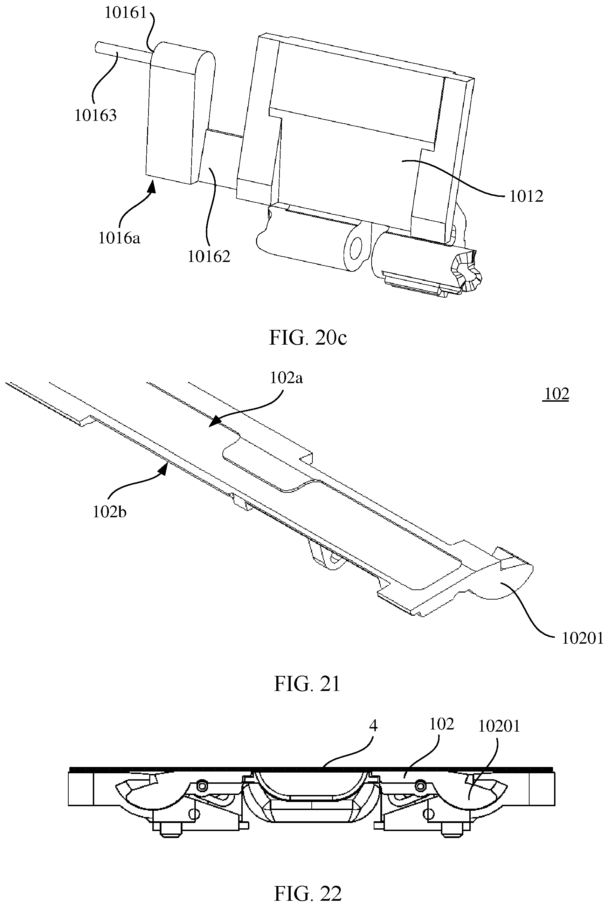

In addition, refer to FIG. 20c. FIG. 20c is a schematic diagram of a structure in which the first drive connecting rod 1016a is connected to the first support arm 1012. In this application, the second connection part 10162 of the first drive connecting rod 1016a may be fastened to the first support arm 1012 through bonding, a threaded connection, or the like. In some other possible embodiments of this application, the first drive connecting rod 1016a and the first support arm 1012 may alternatively be integrally formed.

It may be understood that, in some possible embodiments of this application, the first drive connecting rod 1016a may be alternatively slidably connected to the first support arm 1012 and fastened to the first swing arm 1013. A specific disposing manner is similar to the foregoing embodiment in which the first drive connecting rod 1016a is slidably connected to the first swing arm 1013 and is fastened to the first support arm 1012. Details are not described herein again.

In this disposing manner of the first drive connecting rod 1016a, the first guiding slot 10134 may be properly designed to improve the degrees of bonding between the first support arm 1012 and the first swing arm 1013 and the corresponding sliding grooves. Therefore, the motion consistency between the first support arm 1012 and the first swing arm 1013 is improved, and motion of the first support arm 1012 and the first swing arm 1013 is smoother. In addition, when the electronic device in which the hinge mechanism is used falls in the folded state, the first support arm 1012, the first swing arm 1013, and the first drive connecting rod 1016a may jointly support a housing of the electronic device. Therefore, a large instantaneous displacement of the housing relative to the hinge mechanism can be avoided, to improve the reliability of the overall structure of the electronic device.

In addition, in this embodiment, to avoid the over-constraints caused by the disposing of the first drive connecting rod 1016a on the motion of the first support arm 1012 and the first swing arm 1013, the second sliding block 10132 of the first swing arm 1013 may also be thinned. In this way, the second sliding block 10132 of the first swing arm 1013 is in clearance fit with the second sliding rail 101521 of the first housing mounting bracket 1015. For a specific disposing manner, refer to the foregoing embodiment. Details are not described herein again.

It should be noted that, refer to FIG. 10a. In the second rotating component 101b, a second drive connecting rod 1016b may be disposed between the second support arm 1020 and the second swing arm 1021. The second drive connecting rod 1016b may include a third connection part (not shown in FIG. 10a) and a fourth connection part (not shown in FIG. 10a). The third connection part may be connected to the second swing arm 1021, and the fourth connection part may be connected to the second support arm 1020. For a specific disposing manner of the second drive connecting rod 1016b, a connection mode between the third connection part and the second swing arm 1021, and a connection mode between the fourth connection part and the second support arm 1020, refer to the first rotating component 101a. Details are not described herein again.

Still refer to FIG. 5a. In this application, in addition to the foregoing structure, the hinge mechanism 1 may further include a first support plate 102 and a second support plate 103. The first support plate 102 and the second support plate 103 may be respectively disposed on the two opposite sides of the base 106 shown in FIG. 6. In this application, the first support plate 102 and the second support plate 103 may be symmetrically disposed relative to the base 106. In the following embodiments, a specific disposing manner of the first support plate 102 and a connection relationship between the first support plate 102 and the base 106 are mainly used as examples for description. The second support plate 103 may be disposed with reference to the first support plate 102.

In this application, the first support plate 102 is rotatably connected to the first housing mounting bracket 1015. It should be noted that, in this application, the first support plate 102 may be rotatably connected to a plurality of first housing mounting brackets 1015 of the plurality of main hinge modules 101. This helps simplify the structure of the hinge mechanism 1, and can improve the reliability of the structure of the hinge mechanism 1.

When the first support plate 102 and the first housing mounting bracket 1015 are specifically rotatably connected, first refer to the first housing mounting bracket 1015 shown in FIG. 9. The first housing mounting bracket 1015 may further be provided with a first rotating slot 10153, and the first rotating slot 10153 may be a circular-arc-shaped slot. In addition, refer to FIG. 21. FIG. 21 is a schematic diagram of a structure of the first support plate 102 according to a possible embodiment of this application. A first rotating part 10201 may be disposed at an end that is of the first support plate 102 and that faces the first housing mounting bracket 1015. The first rotating part 10201 may be set to arc-shaped, for example, circular-arc-shaped. In this way, the first rotating part 10201 may be mounted in the first rotating slot 10153, and relative rotation between the first support plate 102 and the first housing mounting bracket 1015 may be implemented by rotating the first rotating part 10201 along a slot surface of the first rotating slot 10153.

Still refer to FIG. 21. The first support plate 102 includes a first plate surface 102a and a second plate surface 102b that are disposed opposite to each other. The first plate surface 102a may be used to support the flexible display. During specific implementation, refer to FIG. 22. FIG. 22 is a schematic diagram of a structure in which the first support plate 102 supports the flexible display 4 according to a possible embodiment of this application. In FIG. 21, the electronic device is in the unfolded state. In this case, the first plate surface 102a of the first support plate 102 and a surface that is of the cover plate (not shown in FIG. 21) and that faces the flexible display 4 may be in a same plane, so that the flexible display 4 can be flatly supported.

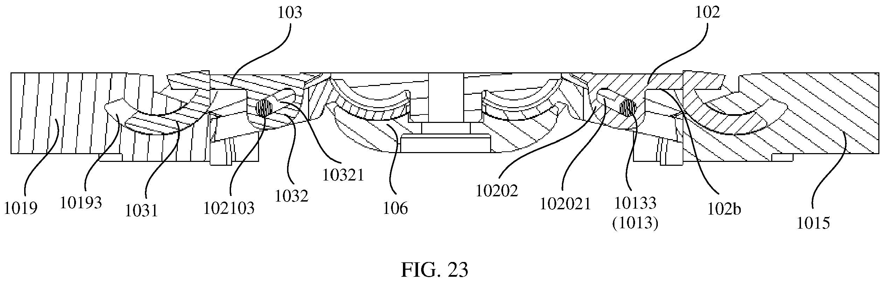

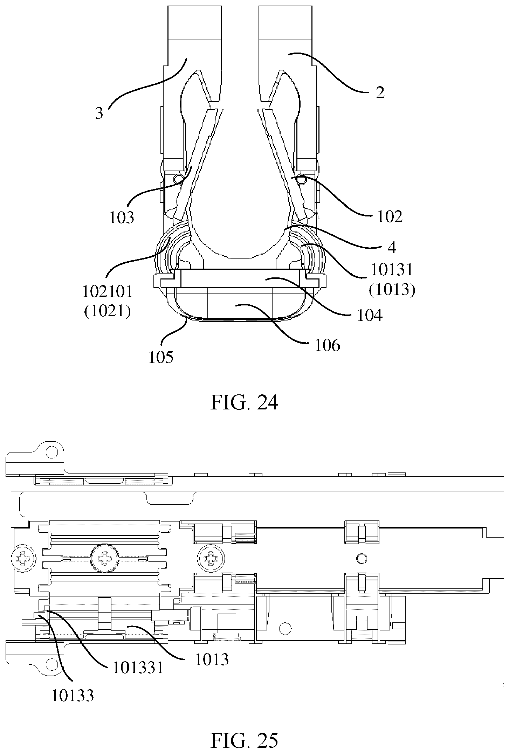

FIG. 23 is a sectional view of the hinge mechanism 1 according to a possible embodiment of this application. FIG. 23 may be used to show a structure of the second plate surface 102b of the first support plate 102 and a connection relationship between the first support plate 102 and another structure. A first guiding part 10202 may be disposed on the second plate surface 102b of the first support plate 102, and a first track slot 102021 may be disposed on the first guiding part 10202. In addition, in this application, a first guiding structure 10133 may further be disposed on the first swing arm 1013. The first guiding structure 10133 may be but is not limited to a columnar structure. The first guiding structure 10133 may be inserted into the first track slot 102021 of the first guiding part 10202 of the first support plate 102 and is capable of sliding along the first track slot 102021. In this way, in a process in which the first swing arm 1013 rotates around the base 106, the first support plate 102 may be driven to rotate around the first housing mounting bracket 1015 on the corresponding side by sliding the first guiding structure 10133 in the first track slot 102021. For example, when the two housing mounting brackets rotate toward to each other, the two swing arms rotate toward to each other around the base 106, so that ends that are of the two support plates and that are close to the base 106 each may be driven to move in a direction away from the base 106. In this way, refer to FIG. 24. FIG. 24 shows that when the electronic device is in the folded state, the first support plate 102, the second support plate 103, and the cover plate 1014 may form a display accommodation space 104, and a bent part of the flexible display 4 may be accommodated in the display accommodation space 104. In this way, the flexible display 4 can be prevented from squeezing, and a risk of damaging the flexible display 4 can be reduced.

It can be learned from the foregoing description that, to facilitate sliding of the first guiding structure 10133 along the first track slot 102021, the first guiding structure 10133 may be disposed as a columnar structure. For example, the first guiding structure 10133 may be a pin shaft. In addition, to drive the first guiding structure 10133 to slide along the first track slot 102021 in the process in which the first swing arm 1013 rotates around the base 106, the first guiding structure 10133 may be connected to the first swing arm 1013, and the first guiding structure 10133 and the first swing arm 1013 can synchronously rotate. A connection mode between the first guiding structure 10133 and the first swing arm 1013 is not specifically limited in this application. For example, refer to FIG. 25. FIG. 25 is a schematic diagram of a partial structure of the hinge mechanism according to a possible embodiment of this application. To facilitate demonstration of a connection relationship between the first guiding structure 10133 and the first swing arm 1013, the first support plate 102 is omitted in FIG. 25 (refer to FIG. 24). In this embodiment, a first protrusion 101331 may be disposed at an end of the first guiding structure 10133, and the first protrusion 101331 may be disposed around a circumferential direction of the end of the first guiding structure 10133. The first protrusion 101331 may be of a contiguous ring-shaped structure disposed around a circumferential direction of the first guiding structure 10133, one or more segmental structures spaced apart around a circumferential direction of the first guiding structure 10133, a plurality of point structures disposed around a circumferential direction of the first guiding structure 10133, or the like.

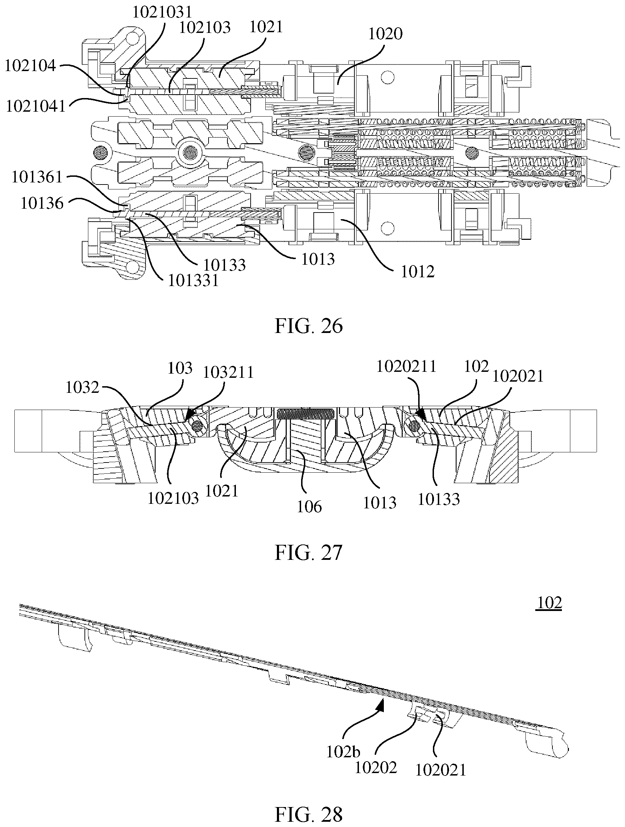

In addition, refer to FIG. 26. FIG. 26 is a sectional view of the hinge mechanism shown in FIG. 25. The first swing arm 1013 may have a first plugging hole 10136, and a first groove 101361 may be disposed on a hole wall of the first plugging hole 10136. In this way, when the first guiding structure 10133 is mounted on the first swing arm 1013, the first guiding structure 10133 may be inserted into the first plugging hole 10136, and the first protrusion 101331 is clamped with the first groove 101361. This implements a connection between the first guiding structure 10133 and the first swing arm 1013. In addition, when the first guiding structure 10133 needs to be detached from the first swing arm 1013, large pull-out force may be applied to the first guiding structure 10133, so that the first protrusion 101331 is detached from the first groove 101361.

In this application, the first guiding structure 10133 and the first swing arm 1013 are detachably connected in a manner of clamping the first protrusion 101331 with the first groove 101361. This effectively reduces connection components between the first guiding structure 10133 and the first swing arm 1013 while reliability of a connection between the first guiding structure 10133 and the first swing arm 1013 can be ensured. Therefore, a structure of the hinge mechanism is simplified. In addition, a detachable connection between the first guiding structure 10133 and the first swing arm 1013 can effectively improve maintenance convenience of the hinge mechanism.

It may be understood that, when the first swing arm 1013 is connected to the first support plate 102 through the first guiding structure 10133, the first guiding structure 10133 may successively pass through the first plugging hole 10136 and the first track slot 102021 (refer to FIG. 23). Assembly of the first guiding structure 10133 with the first swing arm 1013 and the first support plate 102 is completed until the first protrusion 101331 is clamped with the first groove 101361. The assembly mode is convenient and fast, so that assembly efficiency can be effectively improved.

In another possible embodiment of this application, the first support arm 1012 may further drive the first support plate 102 to rotate around the first housing mounting bracket 1015. During specific implementation, the first guiding part 10202 may be disposed on the second plate surface 102b of the first support plate 102, and the first track slot 102021 may be disposed on the first guiding part 10202. In addition, the first guiding structure 10133 may be disposed on the first support arm 1012. The first guiding structure 10133 may be but is not limited to the columnar structure. The first guiding structure 10133 may be inserted into the first track slot 102021 of the first guiding part 10202 of the first support plate 102 and is capable of sliding along the first track slot 102021. In this way, in a process in which the first support arm 1012 rotates around the base 106, the first support plate 102 may be driven to rotate around the first housing mounting bracket 1015 by sliding the first guiding structure 10133 in the first track slot 102021. It may be understood that, in this embodiment, the first guiding structure 10133 may alternatively be disposed with reference to FIG. 25. In addition, the first support arm 1012 may have the first plugging hole 10136, and the first groove 101361 is disposed on the hole wall of the first plugging hole 10136. In this way, a detachable connection between the first guiding structure 10133 and the first support arm 1012 is implemented by clamping the first protrusion 101331 with the first groove 101361.

In some possible embodiments of this application, the first support plate 102 may further be slidably connected to both the first support arm 1012 and the first swing arm 1013. For a slidable connection mode, refer to the foregoing embodiment. Details are not described herein again. Therefore, rotation of the first support arm 1012 and the first swing arm 1013 around the base 106 drives the first support plate 102 to rotate around the first housing mounting bracket 1015. In this embodiment, the first guiding structure 10133 may alternatively be disposed with reference to FIG. 25. The first plugging hole 10136 is disposed on one of the first swing arm 1013 and the first support arm 1012, and the first groove 101361 is disposed on the hole wall of the first plugging hole 10136, to implement detachable connections between the first guiding structure 10133 and the first swing arm 1013 and the first support arm 1012.

In addition to the foregoing clamping manner, the first guiding structure 10133 and the first swing arm 1013 may be connected in another possible manner. For example, refer to FIG. 27. FIG. 27 is a sectional view of the hinge mechanism according to another possible embodiment of this application. In this embodiment, the first guiding structure 10133 is rotatably connected to the first swing arm 1013. During specific implementation, the first guiding structure 10133 and the first swing arm 1013 may be rotatably connected through a pin shaft.

In addition, refer to FIG. 28. FIG. 28 is a schematic diagram of a structure of the first support plate 102 according to another possible embodiment of this application. In this embodiment, the first guiding part 10202 may be disposed on the second plate surface 102b of the first support plate 102, and the first track slot 102021 may be disposed on the first guiding part 10202. The first track slot 102021 may be a sliding groove disposed on the first guiding part 10202. The sliding groove may be, for example, a straight sliding groove.

Still refer to FIG. 27. When the hinge mechanism is in the unfolded state, the first track slot 102021 has a first opening 1020211 disposed toward the base 106, and the first guiding structure 10133 may be inserted into the first track slot 102021 through the first opening 1020211 and is capable of sliding along the first track slot 102021. In this way, in the process in which the first swing arm 1013 rotates around the base 106, the first guiding structure 10133 may be driven to rotate around the first swing arm 1013. In addition, the first support plate 102 is driven to rotate around the first housing mounting bracket 1015 on the corresponding side by sliding the first guiding structure 10133 in the first track slot 102021.

In this embodiment of this application, the first guiding structure 10133 is rotatably connected to the first swing arm 1013, and the first guiding structure 10133 slides along the first track slot 102021 of the first support plate 102. This can effectively improve stability that the first swing arm 1013 drives the first support plate 102 to move. In addition, when the electronic device is in the unfolded state, flatness of supporting the flexible display by the first support plate 102 can be effectively improved. In addition, when the electronic device is in the folded state, a risk of squeezing the flexible display by the first support plate 102 in a process in which the entire device falls can be reduced, to improve the reliability of the structure of the entire device.

It may be understood that, when the structure shown in FIG. 27 is used for the first guiding structure 10133, the first guiding structure 10133 may further be rotatably connected to the first support arm 1012, to drive the first support plate 102 to rotate around the first housing mounting bracket 1015 by rotating the first support arm 1012 around the base 106. Alternatively, the first guiding structure 10133 may be rotatably connected to both the first support arm 1012 and the first swing arm 1013, so that rotation of the first support arm 1012 and the first swing arm 1013 around the base 106 drives the first support plate 102 to rotate around the first housing mounting bracket 1015. For specific connection modes or a specific connection mode between the first guiding structure 10133 and the first support arm 1012 and/or the first swing arm 1013, refer to the embodiment shown in FIG. 27. Details are not described herein again.

Because the second support plate 103 and the first support plate 102 are symmetrically disposed, when the second support plate 103 is specifically disposed, the second support plate 103 may be rotatably connected to the second housing mounting bracket 1019. Still refer to FIG. 23. The second housing mounting bracket 1019 has a second rotating slot 10193. In addition, the second support plate 103 may be provided with a second rotating part 1031, so that the second rotating part 1031 rotates along a slot surface of the second rotating slot 10193. The second support plate 103 may further be provided with a second guiding part 1032, and the second guiding part 1032 has a second track slot 10321. In addition, second guiding structures 102103 or a second guiding structure 102103 may be disposed on the second support arm 1020 and/or the second swing arm 1021. The second guiding structure 102103 may be inserted into the second track slot 10321 and is capable of sliding along the second track slot 10321. Therefore, when the second support arm 1020 and/or the second swing arm 1021 rotate/rotates, the second support plate 103 may be driven to rotate around the second housing mounting bracket 1019 by sliding the second guiding structure 102103 in the second track slot 10321.

In this application, the second guiding structure 102103 may be disposed with reference to the first guiding structure 10133 shown in FIG. 25 and FIG. 26. For example, the second guiding structure 102103 may be disposed as a columnar structure, and may be, for example, a pin shaft. In addition, a second protrusion 1021031 may be disposed at an end of the second guiding structure 102103, and the second protrusion 1021031 may be disposed around a circumferential direction of the end of the second guiding structure 102103. The second protrusion 1021031 may be of a contiguous ring-shaped structure disposed around a circumferential direction of the second guiding structure 102103, one or more intermittent segmental structures disposed around a circumferential direction of the second guiding structure 102103, a plurality of point structures disposed around a circumferential direction of the second guiding structure 102103, or the like. In addition, the second swing arm 1021 or the second support arm 1020 may have a second plugging hole 102104, and a second groove 1021041 may be disposed on a hole wall of the second plugging hole 102104. In this way, the second guiding structure 102103 may be inserted into the second plugging hole 102104, and the second protrusion 1021031 is clamped with the second groove 1021041, to implement a connection between the second guiding structure 102103 and the second swing arm 1021 or the second support arm 1020. In addition, when the second guiding structure 102103 needs to be detached from the second plugging hole 102104, large pull-out force may be applied to the second guiding structure 102103, so that the second protrusion 1021031 is detached from the second groove 1021041. In this way, the second guiding structure 102103 is detachably connected to the second swing arm 1021 and/or the second support arm 1020.

In addition, the second guiding structure 102103 may alternatively be disposed with reference to the first guiding structure 10133 shown in FIG. 27. During specific implementation, the second guiding structure 102103 may be rotatably connected to the second swing arm 1021 and/or the second support arm 1020 through a pin shaft, and the second guiding structure 102103 is capable of sliding along the second track slot 10321 of the second guiding part 1032 of the second support plate 103. It may be understood that, to facilitate sliding of the second guiding structure 102103 in the second track slot 10321, the second support plate 103 may be disposed with reference to the first support plate 102 shown in FIG. 28, and the second track slot 10321 may be a sliding groove disposed on the second guiding part 1032. In addition, refer to FIG. 27. When the hinge mechanism is in the unfolded state, the second track slot 10321 has a second opening 103211 disposed toward the base 106, and the second guiding structure 102103 may be inserted into the second track slot 10321 through the second opening 103211. In this way, in a process in which the second swing arm 1021 and/or the second support arm 1020 rotate/rotates around the base 106, the second guiding structure 102103 may be driven to rotate around the second swing arm 1021 and/or the second support arm 1020. In addition, the second support plate 103 may be driven to rotate around the second housing mounting bracket 1019 on the corresponding side by sliding the second guiding structure 102103 in the second track slot 10321.

In this application, the second guiding structure 102103 is rotatably connected to the second swing arm 1021 and/or the second support arm 1020, and the second guiding structure 102103 slides along the second track slot 10321 of the second support plate 103. This can effectively improve stability that the second swing arm 1021 and/or the second support arm 1020 drive/drives the second support plate 103 to move. In addition, when the electronic device is in the unfolded state, flatness of supporting the flexible display by the second support plate 103 can be effectively improved. In addition, when the electronic device is in the folded state, a risk of squeezing the flexible display by the second support plate 103 in the process in which the entire device falls can be reduced, to improve the reliability of the structure of the entire device.

In this application, the first sliding groove 10151 and the second sliding groove 10152 are disposed on the first housing mounting bracket 1015. In addition, in a process in which the first housing mounting bracket 1015 rotates around the base 106, the first support arm 1012 slides in the first sliding groove 10151 in the first direction, the first swing arm 1013 slides in the second sliding groove 10152 in the second direction, and the projection in the first cross section may intersect the projection in the second direction in the first cross section. The first cross section may be the reference plane perpendicular to the rotation axis of the first support arm 1012 and the rotation axis of the first swing arm 1013. Therefore, when the first support arm 1012 and the first swing arm 1013 rotate around the base 106, the rotation axis centers of the first support arm 1012 and the first arm 1013 do not coincide. In this way, the axis center phase difference between the first support arm 1012 and the first swing arm 1013 can be implemented. In addition, the disposing directions of the first sliding groove 10151 and the second sliding groove 10152 are properly designed, so that both the angles at which the first support arm 1012 and the first swing arm 1013 rotate relative to the base 106 may be less than or equal to 90°. Based on a same principle, both the angles at which the second support arm 1020 and the second swing arm 1021 rotate relative to the base 106 may be less than or equal to 90°.

It may be understood that in the hinge mechanism 1 provided in this application, the first track slot 102021 of the first support plate 102 and the second track slot 10321 of the second support plate 103 may further be adjusted, to implement adjustment of the rotation angles of the first swing arm 1013 and the second swing arm 1021. For example, a maximum angle at which the first swing arm 1013 can rotate may be less than or equal to 90°. When the electronic device is in the folded state, a distance between the first swing arm 1013 and the flexible display 4 may be long, so that the flexible display 4 can be prevented from being squeezed or pulled by the first swing arm 1013. This reduces the risk of damaging the flexible display 4, and prolongs a service life of the flexible display 4.

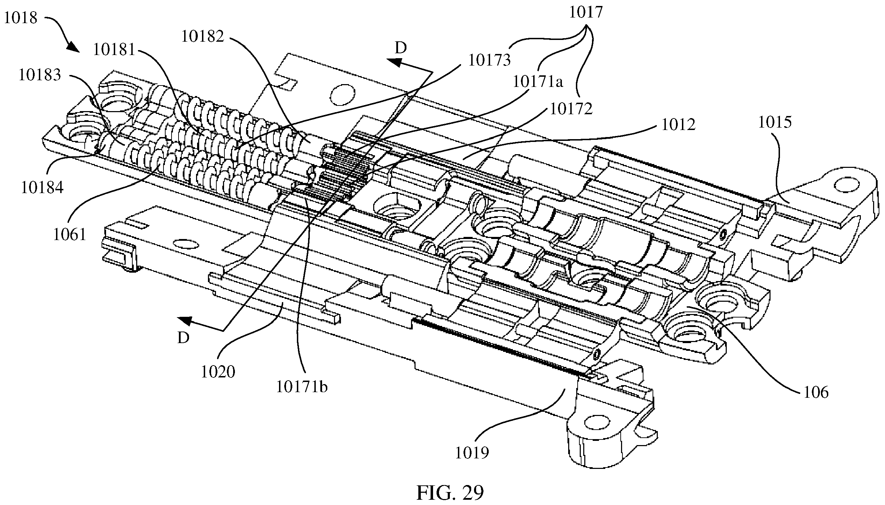

In addition to the foregoing structures, in some embodiments of this application, the hinge mechanism 1 may alternatively be provided with another possible structure. For example, refer to FIG. 29. FIG. 29 is a schematic diagram of a structure of the hinge mechanism according to another embodiment of this application. In this embodiment, the main hinge module 101 may further include a synchronization component 1017. The synchronization component 1017 may include a first drive gear 10171a disposed at an end of the first support arm 1012 and a second drive gear 10171b disposed at an end of the second support arm 1020. The first drive gear 10171a and the second drive gear 10171b mesh with each other. In this way, in a process in which one support arm rotates around the base 106, the other support arm may be driven to synchronously rotate around the base 106 in a toward or opposite direction, and the two support arms rotate at a same angle.

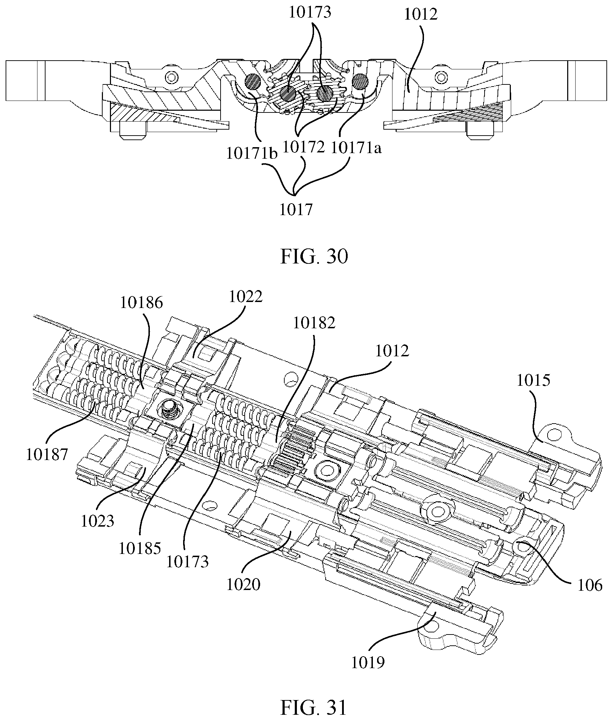

FIG. 30 is a sectional view at a position D-D of the hinge mechanism shown in FIG. 29. In this application, the synchronization component 1017 may further include a driven gear 10172, and the driven gear 10172 may be disposed between the two drive gears. In addition, there may be even number of driven gears 10172, and adjacent driven gears 10172 mesh with each other and the drive gear and an adjacent driven gear 10172 mesh with each other, so that the two drive gears can synchronously rotate through the even number of driven gears 10172.

To improve stability of motion of the synchronization component 1017, in this application, the two drive gears may be respectively sleeved on pin shafts on corresponding sides. In addition, the synchronization component 1017 may further include an intermediate shaft 10173 that may be located between two pin shafts, and each driven gear 10172 is sleeved on one intermediate shaft 10173.

It should be noted that, in this application, the synchronization component 1017 may be disposed on the base 106, and may be accommodated in the accommodation space formed between the cover plate 1014 and the base 106, so that the structure of the hinge mechanism 1 is compact. In the hinge mechanism 1 provided in this application, the synchronization component 1017 is disposed, so that in the process in which one support arm rotates around the base 106, the other support arm may be driven to rotate around the base 106 in the toward or opposite direction. In addition, because each support arm is capable of sliding along a sliding groove of a housing mounting bracket on a corresponding side, in a process in which the support arm rotates around the base 106, a housing mounting bracket on a same side may be driven to rotate at a same angle, so that in a process in which the two support arms synchronously rotate, synchronous rotation of the two housing mounting brackets is implemented. In addition, because the housing mounting brackets may be fastened to the housings of the electronic device, synchronous rotation of the two housing mounting brackets may enable the two housings of the electronic device to synchronously rotate. In this way, instantaneous force can be prevented from being applied to the flexible display 4 fastened to the two housings, to help improve reliability of the flexible display 4.

Still refer to FIG. 29. In this application, the main hinge module 101 may further be provided with a damping component 1018. The damping component 1018 may include a first elastic member 10181 and a first conjoined cam 10182. In a length direction of the main hinge module 101, the first conjoined cam 10182 is located between the first elastic member 10181 and the first support arm 1012, and the first conjoined cam 10182 abuts against the first support arm 1012 under action of elastic force of the first elastic member 10181.

In addition, a first cam surface may be disposed at an end that is of the first support arm 1012 and that faces the first conjoined cam 10182, and a second cam surface may be disposed at an end that is of the second support arm 1020 and that faces the first conjoined cam 10182. When the first support arm 1012 is provided with the first drive gear 10171a, and when the second support arm 1020 is provided with the second drive gear 10171b, the first cam surface may be disposed at an end of the first drive gear 10171a, and the second cam surface may be disposed at an end of the second drive gear 10171b. A third cam surface is disposed at an end that is of the first conjoined cam 10182 and that faces the first support arm 1012, and a fourth cam surface is disposed at an end that is of the first conjoined cam 10182 and that faces the second support arm. In this case, under the elastic force of the first elastic member 10181, the corresponding first cam surface cooperates with the third cam surface, and the second cam surface cooperates with the fourth cam surface.

It should be noted that, in this application, the cam surface includes a plurality of protrusion parts and recessed parts. When slopes of protrusion parts of two cam surfaces are in contact with each other, damping force that prevents the two cam surfaces from continuing to rotate relative to each other may be generated between the two cam surfaces. Based on this, in a process in which the two support arms rotate around the base 106, the damping component 1018 may provide damping force for the two support arms, and the damping force may be transmitted to the first housing mounting bracket 1015 through the first support arm 1012, and transmitted to the second housing mounting bracket 1019 through the second support arm 1020, so that the two housing mounting brackets respectively act on the two housings of the electronic device. In this application, the damping component 1018 is disposed in the main hinge module 101. This can avoid false unfolding and folding of the electronic device, and can implement hovering of the two housings at a set position. In addition, a user may have an obvious feeling in a process of unfolding or folding the electronic device. This helps improve user experience.

When being specifically disposed, the first elastic member 10181 may include a plurality of springs disposed side by side. In addition, a part of the springs in the first elastic member 10181 may be sleeved on the pin shaft 1061, and the other part of the springs may be sleeved on the intermediate shaft 10173. This helps improve stability of motion of the first elastic member 10181.

Still refer to FIG. 29. The damping component 1018 may further include a stopper 10183, and the first elastic member 10181 is located between the stopper 10183 and the first conjoined cam 10182. The stopper 10183 may alternatively be sleeved on the pin shaft 1061 and the intermediate shaft 10173, and the stopper 10183 may be disposed to squeeze the first elastic member 10181, so that the first elastic member 10181 accumulates the elastic force. In addition, the damping component 1018 may further include a circlip 10184. The stopper 10183 is located between the first elastic member 10181 and the circlip 10184, and the circlip 10184 may be clamped on the pin shaft 1061 and the intermediate shaft 10173 to limit the first elastic member 10181 and the first conjoined cam 10182. Therefore, the first elastic member 10181 can be prevented from falling off from the pin shaft 1061 and the intermediate shaft 10173.

It may be understood that, generally, the damping force provided by the damping component 1018 may be increased by adding cam surfaces cooperating with each other. FIG. 31 is a schematic diagram of a partial structure of the hinge mechanism according to another possible embodiment of this application. In this embodiment, the first rotating component 101a may further include a third support arm 1022. The third support arm 1022 may be slidably connected to the first housing mounting bracket 1015, and a direction in which the third support arm 1022 slides along the first housing mounting bracket 1015 is the same as a direction in which the first support arm 1012 slides along the first housing mounting bracket 1015. In addition, the second rotating component 101b may further include a fourth support arm 1023. The fourth support arm 1023 may be slidably connected to the second housing mounting bracket 1019, and a direction in which the fourth support arm 1023 slides along the second housing mounting bracket 1019 is the same as a direction in which the second support arm 1020 slides along the second housing mounting bracket 1019.

The damping component 1018 may further include a second conjoined cam 10185. The first elastic member 10181 is located between the first conjoined cam 10182 and the second conjoined cam 10185, and the first elastic member 10181 presses the second conjoined cam 10185 to the third support arm 1022 and the fourth support arm 1023. A fifth cam surface may be disposed at an end that is of the third support arm 1022 and that faces the second conjoined cam 10185, and a sixth cam surface may be disposed at an end that is of the fourth support arm 1023 and that faces the second conjoined cam 10185. In addition, the second conjoined cam 10185 is provided with a seventh cam surface and an eighth cam surface. Under the action of the elastic force of the first elastic member 10181, the fifth cam surface cooperates with the seventh cam surface, and the sixth cam surface cooperates with the eighth cam surface.

When the damping force provided by the damping component 1018 needs to be further increased, still refer FIG. 31. The damping component 1018 may further include a third conjoined cam 10186. The third support arm 1022 may be located between the second conjoined cam 10185 and the third conjoined cam 10186, and the fourth support arm 1023 may be located between the second conjoined cam 10185 and the third conjoined cam 10186. In addition, the damping component 1018 may further include a second elastic member 10187. The second elastic member 10187 may press the third conjoined cam 10186 to the third support arm 1022 and the fourth support arm 1023. A ninth cam surface may be disposed at an end that is of the third support arm 1022 and that faces the third conjoined cam 10186, and a tenth cam surface may be disposed at an end that is of the fourth support arm 1023 and that faces the third conj oined cam 10186. In addition, the third conjoined cam 10186 is provided with an eleventh cam surface and a twelfth cam surface. Under action of elastic force of the second elastic member 10187, the ninth cam surface cooperates with the eleventh cam surface, and the tenth cam surface cooperates with the twelfth cam surface.

In the hinge mechanism, a plurality of cam surfaces cooperating with each other are disposed to increase the damping force provided by the damping component 1018 for the electronic device, so that false unfolding and folding of the electronic device can be avoided, and the two housings can be hovered at the set position. In addition, the user may have the obvious feeling in the process of unfolding or folding the electronic device. This helps improve user experience.

The hinge mechanism 1 provided in the foregoing embodiments of this application may be used in, but is not limited to, for example, the electronic device shown in FIG. 4. Refer to FIG. 29 or FIG. 31. The two housing mounting brackets of the main hinge module 101 may be respectively fastened to the housings on a same side of the base 106. For example, the first housing mounting bracket 1015 may be configured to be fastened to the first housing 2 of the electronic device shown in FIG. 4, and the second housing mounting bracket 1019 may be configured to be fastened to the second housing 3 of the electronic device shown in FIG. 4.

In the electronic device provided in this application, when the electronic device is in the unfolded state, the first support plate 102, the second support plate 103, and the cover plate 1014 of the hinge mechanism 1 may flatly support the flexible display 4. This can ensure that a form of the electronic device in the unfolded state is complete, and help improve light and shadow of the flexible display 4. In a process in which the electronic device rotates around the hinge mechanism 1 from the unfolded state to the folded state, the first housing 2 and the second housing 3 of the electronic device may respectively drive the housing mounting brackets on the corresponding sides to rotate around the base 106. Therefore, a housing mounting bracket can drive a support arm and a swing arm that are disposed on a same side to rotate around the base 106.

In this way, two sliding grooves of each housing mounting bracket are properly designed, so that angles at which a support arm and a swing arm on a corresponding side rotate relative to the base 106 can be adjusted. For example, refer to FIG. 7 and FIG. 24. When the electronic device is in the folded state, a distance between the first arc-shaped rotation block 10131 of the first swing arm 1013 and the flexible display 4 may be long. Similarly, a distance between the second arc-shaped rotation block 102101 of the second swing arm 1021 and the flexible display 4 is long. In this way, the arc-shaped rotation blocks of the two swing arms can be prevented from squeezing or pulling the flexible display 4. This reduces the risk of damaging the flexible display 4, and prolongs the service life of the flexible display 4.

It should be noted that, still refer to FIG. 24. In this application, when the hinge mechanism is provided with the first support plate 102 and the second support plate 103, the flexible display 4 of the electronic device may be fastened to the first support plate 102 and the second support plate 103. A connection mode may be but is not limited to bonding. During specific implementation, the flexible display 4 may be bonded to a partial area of the first support plate 102. For example, the flexible display 4 may be bonded to a part that is of the first support plate 102 and that is close to the base 106. In addition, the flexible display 4 may be bonded to a partial area of the second support plate 103. For example, the flexible display 4 may be bonded to a part that is of the second support plate 103 and that is close to the substrate 101. Therefore, when the electronic device is in the unfolded state, the first housing 2, the second housing 3, the first support plate 102, and the second support plate 103 jointly stably support the flexible display 4. This can help improve the light and shadow of the flexible display. In a process in which the electronic device changes from the unfolded state to the folded state, the two support plates can drive the flexible display to rotate. This can effectively avoid deformation of the flexible display 4, and reduce the risk of damaging the flexible display. In addition, when the electronic device is in the folded state shown in FIG. 24, the flexible display 4 can be attached to the two support plates. This can effectively improve bending reliability of the flexible display 4.

In addition, in this application, the track slots of the two support plates may be properly designed, so that when the electronic device is in the folded state, the enough accommodation space is formed between the two support plates and the cover plate 1014 to accommodate the bent part of the flexible display 4. This can avoid a gap at the hinge mechanism 1 of the electronic device, and ensure that a form of the electronic device in the folded state is complete. In this way, damage to the flexible display 4 caused by a foreign matter inserted into the electronic device at the hinge mechanism 1 can be avoided, and an overall thickness of the electronic device can be thinned.

In addition, as shown in FIG. 4, a first groove 201 may be disposed at an end that is of the first housing 2 and that faces the hinge mechanism 1, and a second groove 301 may be disposed at an end that is of the second housing 3 and that faces the hinge mechanism 1. One first housing mounting bracket 1015 may be accommodated in the first groove 201, and another first housing mounting bracket 1015 may be accommodated in the second groove 301. In this way, when the electronic device is in the unfolded state, the hinge mechanism 1 may be accommodated in an accommodation part formed by folding the first groove 201 and the second groove 301, so that the electronic device has appearance effect of an integrated design. This improves appearance aesthetics of the electronic device.

In addition, refer to FIG. 5a and FIG. 24. In this application, the hinge mechanism may further include an end cover 105, and the end cover 105 may be disposed on a side that is of the base 106 and that is away from the flexible display 4. In a possible embodiment of this application, the end cover 105 and the base 106 may be integrally formed, to improve the reliability of the structure of the hinge mechanism and simplify the structure of the hinge mechanism. In some other possible embodiments of this application, the end cover 105 may alternatively be a structure independently disposed with the base 106, and the end cover 105 may be fastened to the base 106. A connection mode may be, but is not limited to, bonding, the threaded connection, or the like. In this way, the end cover 105 may be used as an appearance part of the hinge mechanism. The end cover 105 may protect the another structure of the hinge mechanism, and help improve appearance aesthetics of the hinge mechanism. This improves the overall appearance aesthetics of the electronic device.

The foregoing descriptions are merely specific implementations of this application, but are not intended to limit the protection scope of this application. Any variation or replacement readily figured out by a person skilled in the art within the technical scope disclosed in this application shall fall within the protection scope of this application. Therefore, the protection scope of this application shall be subject to the protection scope of the claims.

## Claims

1. A hinge mechanism, used in a foldable electronic device, wherein the hinge mechanism is disposed corresponding to a bendable part of a flexible display of the electronic device, and comprises a base and a main hinge module; and the main hinge module comprises a first rotating component and a second rotating component, wherein
the first rotating component and the second rotating component are located on two opposite sides of the base, the first rotating component comprises a first support arm, a first swing arm, and a first housing mounting bracket, and the second rotating component comprises a second support arm, a second swing arm, and a second housing mounting bracket;
the first support arm and the second support arm are separately rotatably connected to the base, and the first swing arm and the second swing arm are separately rotatably connected to the base; and a rotation axis of the first support arm is parallel to and does not coincide with a rotation axis of the first swing arm, and a rotation axis of the second support arm is parallel to and does not coincide with a rotation axis of the second swing arm;
a first sliding groove extending in a first direction and a second sliding groove extending in a second direction are disposed on the first housing mounting bracket, the first support arm is capable of sliding in the first sliding groove, the first swing arm is capable of sliding in the second sliding groove, a projection in the first direction in a first cross section is not parallel to a projection in the second direction in the first cross section, and the first cross section is a reference plane perpendicular to the rotation axis of the first support arm and the rotation axis of the first swing arm; and
a third sliding groove extending in a third direction and a fourth sliding groove extending in a fourth direction are disposed on the second housing mounting bracket, the second support arm is capable of sliding in the third sliding groove, the second swing arm is capable of sliding in the fourth sliding groove, a projection in the third direction in a second cross section is not parallel to a projection in the fourth direction in the second cross section, and the second cross section is a reference plane perpendicular to the rotation axis of the second support arm and the rotation axis of the second swing arm.

2. The hinge mechanism according to claim 1, wherein neither of angles at which the first support arm and the first swing arm rotate relative to the base is greater than 90°, and neither of angles at which the second support arm and the second swing arm rotate relative to the base is greater than 90°.

3. The hinge mechanism according to claim 1 or 2, wherein a first arc-shaped slot and a second arc-shaped slot are disposed on the base, and a first arc-shaped rotation block is disposed at an end that is of the first swing arm and that is used to rotatably connect to the base; and the first arc-shaped rotation block is accommodated in the first arc-shaped slot and is capable of rotating along an arc-shaped surface of the first arc-shaped slot; and
a second arc-shaped rotation block is disposed at an end that is of the second swing arm and that is used to rotatably connect to the base; and the second arc-shaped rotation block is accommodated in the second arc-shaped slot and is capable of rotating along an arc-shaped surface of the second arc-shaped slot.

4. The hinge mechanism according to claim 3, wherein the hinge mechanism further comprises a cover plate, the cover plate covers the base, a first arc-shaped protrusion is disposed on a surface that is of the cover plate and that faces the first arc-shaped slot, and the first arc-shaped rotation block is inserted between the first arc-shaped protrusion and the first arc-shaped slot; and
a second arc-shaped protrusion is disposed on a surface that is of the cover plate and that faces the second arc-shaped slot, and the second arc-shaped rotation block is inserted between the second arc-shaped protrusion and the second arc-shaped slot.

5. The hinge mechanism according to any one of claims 1 to 4, wherein a second sliding rail is disposed on the second sliding groove; a second sliding block is disposed on the first swing arm; and the second sliding block is clamped in the second sliding rail, and the second sliding block is capable of sliding along the second sliding rail; and
a fourth sliding rail is disposed on the fourth sliding groove; a fourth sliding block is disposed on the second swing arm; and the fourth sliding block is clamped in the fourth sliding rail, and the fourth sliding block is capable of sliding along the fourth sliding rail.

6. The hinge mechanism according to claim 5, wherein the second sliding rail is a straight-line sliding rail, and the fourth sliding rail is a straight-line sliding rail.

7. The hinge mechanism according to claim 6, wherein the first housing mounting bracket comprises a first surface, and the first surface is a surface of a side that is of the first housing mounting bracket and that faces the flexible display; the second sliding block is a straight-line sliding block, and the second sliding rail is the straight-line sliding rail; the straight-line sliding rail has an opening located on the first surface; and when the hinge mechanism is in an unfolded state, the straight-line sliding rail extends from the opening to the base; and
the second housing mounting bracket comprises a third surface, and the third surface is a surface of a side that is of the second housing mounting bracket and that faces the flexible display; the fourth sliding block is a straight-line sliding block, and the fourth sliding rail is the straight-line sliding rail; the straight-line sliding rail has an opening located on the third surface; and when the hinge mechanism is in the unfolded state, the straight-line sliding rail extends from the opening to the base.

8. The hinge mechanism according to claim 5, wherein the second sliding rail is an arc-shaped sliding rail, and the fourth sliding rail is an arc-shaped sliding rail.

9. The hinge mechanism according to claim 8, wherein when the hinge mechanism is in an unfolded state, an axis center of the arc-shaped sliding rail is located on a side that is of the arc-shaped sliding rail and that is away from the base.

10. The hinge mechanism according to any one of claims 1 to 9, wherein the main hinge module further comprises a first drive connecting rod and a second drive connecting rod, the first drive connecting rod is located between the first support arm and the first swing arm, the first drive connecting rod comprises a first connection part and a second connection part, the first connection part is rotatably connected to the first support arm through a first connecting rod, the second connection part is rotatably connected to the first swing arm through a second connecting rod, and axes of the first connecting rod and the second connecting rod are parallel and do not coincide; and
the second drive connecting rod is located between the second support arm and the second swing arm, the second drive connecting rod comprises a third connection part and a fourth connection part, the third connection part is rotatably connected to the second support arm through a third connecting rod, the fourth connection part is rotatably connected to the second swing arm through a fourth connecting rod, and axes of the third connecting rod and the fourth connecting rod are parallel and do not coincide.

11. The hinge mechanism according to any one of claims 1 to 9, wherein the main hinge module further comprises a first drive connecting rod and a second drive connecting rod, the first drive connecting rod is located between the first support arm and the first swing arm, the first drive connecting rod comprises a first connection part and a second connection part, the first connection part is slidably connected to the first swing arm through a first connecting rod, and the second connection part is fastened to the first support arm; and
the second drive connecting rod is located between the second support arm and the second swing arm, the second drive connecting rod comprises a third connection part and a fourth connection part, the third connection part is slidably connected to the second swing arm through a third connecting rod, and the fourth connection part is fastened to the second support arm.

12. The hinge mechanism according to claim 11, wherein a first guiding slot is disposed at an end that is of the first swing arm and that faces the first support arm, and the first connecting rod is inserted into the first guiding slot and is capable of sliding along a slot surface of the first guiding slot; and
a second guiding slot is disposed at an end that is of the second swing arm and that faces the second support arm, and the third connecting rod is inserted into the second guiding slot and is capable of sliding along a slot surface of the second guiding slot.

13. The hinge mechanism according to any one of claims 10 to 12, wherein the second sliding rail is disposed on the second sliding groove; the second sliding block is disposed on the first swing arm; and the second sliding block is capable of sliding along the second sliding rail, and the second sliding block is in clearance fit with the second sliding rail; and
the fourth sliding rail is disposed on the fourth sliding groove; the fourth sliding block is disposed on the second swing arm; and the fourth sliding block is capable of sliding along the fourth sliding rail, and the fourth sliding block is in clearance fit with the fourth sliding rail.

14. The hinge mechanism according to claim 13, wherein a shape of the second sliding block matches a shape of the second sliding rail, or the second sliding block is a pin shaft; and
a shape of the fourth sliding block matches a shape of the fourth sliding rail, or the fourth sliding block is a pin shaft.

15. The hinge mechanism according to any one of claims 1 to 14, wherein the hinge mechanism further comprises a first support plate and a second support plate, and the first support plate and the second support plate are respectively disposed on two sides of the base; the first support plate is rotatably connected to the first housing mounting bracket, and the first support plate is slidably connected to the first support arm and/or the first swing arm; and the second support plate is rotatably connected to the second housing mounting bracket, and the second support plate is slidably connected to the second support arm and/or the second swing arm; and
when the first housing mounting bracket and the second housing mounting bracket rotate toward each other, an end that is of the first support plate and that is close to the base moves in a direction away from the base, and an end that is of the second support plate and that is close to the base moves in a direction away from the base.

16. The hinge mechanism according to claim 15, wherein the first housing mounting bracket is provided with a first rotating slot, the first support plate is provided with a first rotating part, the first rotating part is mounted in the first rotating slot, and the first rotating part is capable of rotating along a slot surface of the first rotating slot; and
the second housing mounting bracket is provided with a second rotating slot, the second support plate is provided with a second rotating part, the second rotating part is mounted in the second rotating slot, and the second rotating part is capable of rotating along a slot surface of the second rotating slot.

17. The hinge mechanism according to claim 15 or 16, wherein the first support plate is provided with a first guiding part, and the first guiding part has a first track slot; and a first guiding structure is disposed on the first swing arm, and the first guiding structure is inserted into the first track slot and is capable of sliding along the first track slot; and/or a first guiding structure is disposed on the first support arm, and the first guiding structure is inserted into the first track slot and is capable of sliding along the first track slot; and
the second support plate is provided with a second guiding part, and the second guiding part has a second track slot; and a second guiding structure is disposed on the second swing arm, and the second guiding structure is inserted into the second track slot and is capable of sliding along the second track slot; and/or a second guiding structure is disposed on the second support arm, and the second guiding structure is inserted into the second track slot and is capable of sliding along the second track slot.

18. The hinge mechanism according to claim 17, wherein the first guiding structure is disposed on the first swing arm, a first protrusion is disposed at an end of the first guiding structure, the first swing arm has a first plugging hole, a first groove is disposed on a hole wall of the first plugging hole, the first guiding structure is inserted into the first plugging hole, and the first protrusion is clamped with the first groove; or the first guiding structure is disposed on the first support arm, a first protrusion is disposed at an end of the first guiding structure, the first support arm has a first plugging hole, a first groove is disposed on a hole wall of the first plugging hole, the first guiding structure is inserted into the first plugging hole, and the first protrusion is clamped with the first groove; and
the second guiding structure is disposed on the second swing arm, a second protrusion is disposed at an end of the second guiding structure, the second swing arm has a second plugging hole, a second groove is disposed on a hole wall of the second plugging hole, the second guiding structure is inserted into the second plugging hole, and the second protrusion is clamped with the second groove; or the second guiding structure is disposed on the second support arm, a second protrusion is disposed at an end of the second guiding structure, the second support arm has a second plugging hole, a second groove is disposed on a hole wall of the second plugging hole, the second guiding structure is inserted into the second plugging hole, and the second protrusion is clamped with the second groove.

19. The hinge mechanism according to claim 17, wherein the first guiding structure is disposed on the first swing arm, and the first guiding structure is rotatably connected to the first swing arm; and/or the first guiding structure is disposed on the first support arm, and the first guiding structure is rotatably connected to the first support arm; and
the second guiding structure is disposed on the second swing arm, and the second guiding structure is rotatably connected to the second swing arm; and/or the second guiding structure is disposed on the second support arm, and the second guiding structure is rotatably connected to the second support arm.

20. The hinge mechanism according to claim 19, wherein when the hinge mechanism is in the unfolded state, the first track slot has a first opening facing the base, and the first guiding structure is inserted into the first track slot through the first opening; and
when the hinge mechanism is in the unfolded state, the second track slot has a second opening facing the base, and the second guiding structure is inserted into the second track slot through the second opening.

21. An electronic device, comprising a first housing, a second housing, a flexible display, and the hinge mechanism according to any one of claims 1 to 20, wherein
the first housing and the second housing are respectively disposed on two opposite sides of the hinge mechanism, the first housing mounting bracket is fastened to the first housing, and the second housing mounting bracket is fastened to the second housing; and
the flexible display contiguously covers the first housing, the second housing, and the hinge mechanism, and the flexible display is fastened to the first housing and the second housing.

22. The electronic device according to claim 21, wherein when the hinge mechanism further comprises a first support plate and a second support plate, the first support plate and the second support plate are respectively disposed on two sides of the base, the first support plate is rotatably connected to the first housing mounting bracket, and the second support plate is rotatably connected to the second housing mounting bracket; and
the flexible display is bonded to the first support plate and the second support plate.

23. The electronic device according to claim 22, wherein the flexible display is bonded to a partial area of the first support plate, and the flexible display is bonded to a partial area of the second support plate.

24. The electronic device according to any one of claims 21 to 23, wherein the electronic device further comprises an end cover, the end cover is located on a side that is of the base and that is away from the flexible display, and the end cover and the base are integrally formed.
